# EUROPEAN PATENT SPECIFICATION

(11) **EP 3 342 525 B1**
(45) Date of publication and mention of the grant of the patent: **21.10.2020**
(21) Application number: 16839196.9
(22) Date of filing: 19.08.2016
(51) Int. Cl.: B23K 20/12, B23K 101/14, B23K 103/10, B23K 103/12, B23K 103/14, B23K 103/08, B23K 103/18

(54) **METHOD FOR MANUFACTURING LIQUID-COOLED JACKET, AND LIQUID-COOLED JACKET**
VERFAHREN ZUR HERSTELLUNG EINES FLÜSSIGKEITSGEKÜHLTEN MANTELS UND FLÜSSIGKEITSGEKÜHLTER MANTEL
PROCÉDÉ DE FABRICATION D'UNE CHEMISE REFROIDIE PAR UN LIQUIDE ET CHEMISE REFROIDIE PAR UN LIQUIDE

(30) Priority: 26.08.2015 JP 2015166411; 19.05.2016 JP 2016100366; 19.05.2016 JP 2016100367
(43) Date of publication of application: 04.07.2018
(73) Proprietor: Nippon Light Metal Company, Ltd., Tokyo 140-8628 (JP)
(72) Inventor: HORI, Hisashi, Shizuoka-shi Shizuoka 421-3203 (JP); SEO, Nobushiro, Shizuoka-shi Shizuoka 421-3203 (JP)
(74) Representative: Kiwit, Benedikt
(86) International application number: PCT/JP2016/074190
(87) International publication number: WO 2017/033849

(56) References cited:
- WO-A1-2015/107716
- WO-A1-2016/072211
- JP-A- S52 123 358
- JP-A- 2002 035 962
- JP-A- 2005 103 617
- JP-A- 2006 324 647
- JP-A- 2006 324 647
- JP-A- 2015 131 321
- JP-A- 2015 131 323

## Description

### TECHNICAL FIELD

The present invention relates to a method for manufacturing a liquid-cooled jacket, and a liquid-cooled jacket.

### BACKGROUND ART

As a method for joining metal members to each other, friction stir welding (FSW = Friction Stir Welding) is known. In the friction stir welding, a rotary tool is rotated and moved in a portion of the metal members that are pressed (butted) with each other to let metal at the portion flow plastically by frictional heat between the rotary tool and the metal members, to join the metal members by solid-phase welding.

Recently, as the performance of electronic devices such as personal computers is improved, the heat quantity from a CPU (heating element) to be mounted increases, so that cooling the CPU is increasingly important. Conventionally, a heat sink using a cooling-fan has been used to cool the CPU. However, problems such as fan noise and limitation of air cooling are highlighted, and a liquid-cooled jacket is attracting attention as a next-generation cooling system.

JP 2015 131323 A shows a manufacturing method which includes a preparation process of overlapping an end surface and a reverse surface of a sealing body by placing the sealing body on the end surface of a sidewall part and a regular joining process of executing frictional agitation joining by making a round around a recessed part while moving a regular joining rotary tool along a first overlapping part overlapped in the preparation process. The regular joining rotary tool has an agitation pin of a length dimension larger than a thickness dimension of the sealing body, is used in the regular joining process. Frictional agitation is executed in a state of contacting only the agitation pin with a jacket body and the sealing body.
JP 2006 324647 A shows a water cooling jacket in which the CPU is attached in a predetermined position. Heat generated from the CPU is transmitted to cooling water being supplied from an external heat transport fluid supply means and circulating the interior, which includes a first passage by the side of the heat transport fluid supply means, a second passage group which has a plurality of second passages branching from the first passage and a third passage which gathers a plurality of second passages at the downstream of the plurality of second passages.
Patent Document 1 discloses a liquid-cooled jacket having a jacket body and a seal body having a plurality of fins arranged in parallel on a substrate. The substrate in the seal body is formed of layers of different metal layers being overlaid, to enhance the heat conductivity by taking advantage of the characteristics of respective metal materials. In the invention according to Patent Document 1, the jacket body is joined with the seal body by screws.

### PRIOR ART DOCUMENTS

### PATENT DOCUMENT

Patent Document 1: Japanese Patent No. 5572678

### SUMMARY OF THE INVENTION

### PROBLEMS TO BE SOLVED BY THE INVENTION

In the conventional method for manufacturing a liquid-cooled jacket, the jacket body is joined with the seal body by screws, to cause a problem of water-tightness and air-tightness of the liquid-cooled jacket being deteriorated. Friction stir joining may be used to join the jacket body and the seal body, but if the rotary tool is inserted in the substrate formed of different types of metals being overlaid, there is a problem that setting a joining condition such as rotational speed and feeding speed is difficult due to different characteristics of respective metals.

Accordingly, the present invention provides a method for manufacturing a liquid-cooled jacket, and a liquid-cooled jacket that has high water-tightness and air-tightness and is manufactured easily.

### MEANS TO SOLVE THE PROBLEMS

To solve the problems above, the present invention intends to provide a method for manufacturing a liquid-cooled jacket, including steps of: preparing to form a jacket body that has a bottom and a peripheral wall extending upward from a peripheral edge of the bottom, as well as a seal body that has a first substrate formed of a first metal in a plate shape, a second substrate formed of a second metal in a plate shape on a front face of the first substrate so as to have a peripheral edge of the first substrate be exposed, and a plurality of fins arranged in parallel on a rear face of the first substrate; arranging the seal body on the jacket body to form an overlaid portion with an end face of the peripheral wall and a rear face of the first substrate overlaid thereon; and joining by friction stir the overlaid portion by inserting a rotary tool from a front face of the peripheral edge of the first substrate and by moving the rotary tool along the overlaid portion relatively in a state where a stirring pin of the rotary tool is contacted with only the first substrate or with both the first substrate and the peripheral wall.

Further, the present invention provides a liquid-cooled jacket having: a jacket body that has a bottom and a peripheral wall extending upward from a peripheral edge of the bottom; and a seal body that has a first substrate in a plate shape formed of a first metal, a second substrate in a plate shape formed of a second metal on a front face of the first substrate so as to have a peripheral edge of the first substrate be exposed, and a plurality of fins arranged in parallel on a rear face of the first substrate, wherein friction stir joining is applied to an overlaid portion formed with an end face of the peripheral wall and a rear face of the seal body overlaid thereon, to form a plasticized region along the peripheral edge of the first substrate.

According to the manufacturing method, the jacket body is joined by friction stir with the seal body, to enhance the water-tightness and the air tightness. Further, the seal body is formed to have the peripheral edge of the first substrate formed of the first metal exposed and the peripheral edge is joined by friction stir, to eliminate the effect from the second metal. This allows the joining condition for the friction stir joining to be easily set.

Further, the preparing step preferably includes steps of: forming a clad that has a first base formed of the first metal cladded on a second base formed of the second metal; first cutting to cut the first base so as to form the first substrate and a block; second cutting to cut the second base so as to have the peripheral edge of the first substrate be exposed and form the second substrate; and fin forming to cut the block with a multi-cutter having disc cutters arranged in parallel so as to form the plurality of fins.

According to the manufacturing method, the seal body having the first substrate, the second substrate and the plurality of fins is easily manufactured.

Further, in the joining step, friction stir joining is preferably applied to the overlaid portion in a state where only the stirring pin of the rotary tool is contacted with only the first substrate or with both the first substrate and the peripheral wall.

According to the manufacturing method, since only the stirring pin is contacted, the friction stir joining is applied with a friction stir device having a small load.

Further, in the joining step, preferably, a joining condition is set to generate a burr outside the first substrate, and the method further includes: removing a redundant portion of the first substrate along a recessed groove formed in a plasticized region as a boundary.

According to the manufacturing method, the burr generated during the friction stir joining is easily removed as part of the redundant portion.

Further, in the preparing step, a support having a protrusion on an end face thereof is formed on the bottom of the jacket body, the first substrate is formed to have a hole therein and the second substrate is formed to have a vicinity of the hole be exposed on a front face of the first substrate, in the arranging step, the overlaid portion is formed and the protrusion is inserted in the hole, and in the joining step, friction stir joining is applied to a butted portion that is formed with an outer periphery of the protrusion butted with a wall of the hole.

According to the manufacturing method, since the protrusion formed on the support is inserted in the hole formed in the seal body, the seal body is easily positioned. Further, the support is joined with the seal body, to enhance the strength of the liquid-cooled jacket.

Further, the first metal is preferably made of aluminum alloy and the second metal is made of copper alloy.

According to the manufacturing method, the heat conductivity of the liquid-cooled jacket is enhanced.

To solve the problems above, the present invention provides a method for manufacturing a liquid-cooled jacket, including steps of: preparing to form a jacket body that has a bottom, a peripheral wall that extends upward from a peripheral edge of the bottom, a stepped bottom face that is formed lower than an end face of the peripheral wall by one step, and a stepped side face that extends upward from the stepped bottom face, as well as a seal body that has a first substrate formed of a first metal in a plate shape, a second substrate formed of a second metal in a plate shape on a front face of the first substrate so as to have a peripheral edge of the first substrate be exposed, and a plurality of fins arranged in parallel on a rear face of the first substrate; seal body arranging to arrange the seal body on the jacket body, so as to butt the stepped side face with a side face of the first substrate to form a first butted portion; and joining by friction stir the first butted portion by inserting a rotary tool and by moving the rotary tool along the first butted portion relatively in a state where a stirring pin of the rotary tool is contacted with both the first substrate and the peripheral wall.

Further, the present invention provides a liquid-cooled jacket having: a jacket body that has a bottom, a peripheral wall extending upward from a peripheral edge of the bottom, and a stepped portion formed at an inner peripheral edge of the peripheral wall; and a seal body that has a first substrate formed of a first metal in a plate shape, a second substrate formed of a second metal in a plate shape so as to have a peripheral edge of the first substrate be exposed on a front face of the first substrate, and a plurality of fins arranged in parallel on a rear face of the first substrate, wherein friction stir joining is applied to a first butted portion that is formed with a stepped side face of the stepped portion butted with a side face of the first substrate, and a plasticized region is formed in the peripheral edge of the first substrate.

According to the manufacturing method, since the jacket body is joined by friction stir with the seal body, the water-tightness and the air tightness are enhanced. Further, the seal body is formed to have the peripheral edge of the first substrate formed of the first metal exposed and the peripheral edge is joined by friction stir, to eliminate the effect of the second metal. Accordingly, the joining condition for the friction stir joining is easily set.

Further, the preparing step preferably includes steps of: forming a clad that has a first base formed of the first metal cladded on a second base formed of the second metal; first cutting to cut the first base so as to form the first substrate and a block; second cutting to cut the second base so as to have the peripheral edge of the first substrate exposed and form the second substrate; and fin forming to cut the block with a multi-cutter having disc cutters in parallel so as to form the plurality of fins.

According to the manufacturing method, the seal body having the first substrate, the second substrate and the plurality of fins is easily manufactured.

Further, in the joining step, friction stir joining is preferably applied in a state where only the stirring pin of the rotary tool is contacted with the peripheral wall and the first substrate.

According to the manufacturing method, a deep position in the first butted portion is joined by friction stir with a friction stir device applied with a small load.

Further, the method preferably includes: auxiliary member arranging to arrange an auxiliary member along the first butted portion, wherein, in the joining step, friction stir joining is applied to the first butted portion in a state where only the stirring pin is contacted with the peripheral wall, the first substrate and the auxiliary member.

According to the manufacturing method, friction stir joining is applied to the auxiliary member, in addition to the peripheral wall and the first substrate, to prevent short supply of metal at the joined portion.

Further, in the joining step, a joining condition is preferably set to generate a burr on the auxiliary member, and the method further includes: removing the auxiliary member generated with the burr.

According to the manufacturing method, the burr is easily removed.

Further, in the joining step, friction stir joining is preferably applied in a state where a center axis for rotation of the rotary tool is inclined toward an inside of the jacket body.

According to the manufacturing method, the stirring pin is easily inserted.

Further, in the preparing step, a support having a protrusion on an end face thereof is formed on the bottom of the jacket body, the first substrate is formed to have a hole therein and the second substrate is formed to have a vicinity of the hole be exposed on a front face of the first substrate, in the seal body arranging step, the first butted portion is formed and the protrusion is inserted in the hole, and in the joining step, friction stir joining is applied to a second butted portion formed with an outer periphery of the protrusion butted with a wall of the hole.

According to the manufacturing method, since the protrusion formed on the support is inserted in the hole formed in the seal body, the seal body is easily positioned. Further, the support is joined with the seal body, to enhance the strength of the liquid-cooled jacket.

Further, the first metal is preferably made of aluminum alloy and the second metal is made of copper alloy.

According to the manufacturing method, the heat conductivity of the liquid-cooled jacket is enhanced.

Further, a support having a protrusion on an end face thereof is formed on the bottom of the jacket body, the first substrate is formed to have a hole therein and the second substrate is formed to have a vicinity of the hole be exposed, and friction stir joining is applied to a second butted portion that is formed with an outer periphery of the protrusion butted with a wall of the hole.

According to the structure, since the protrusion formed on the support is inserted in the hole formed in the seal body, the seal body is easily positioned. Further, the support is joined with the seal body, to enhance the strength of the liquid-cooled jacket.

### ADVANTAGEOUS EFFECTS OF THE INVENTION

According to the method for manufacturing a liquid-cooled jacket and the liquid-cooled jacket of the present invention, a liquid-cooled jacket is easily manufactured to have highly water-tightness and air-tightness.

### BRIEF DESCRIPTION OF THE DRAWINGS

FIG. 1 is a perspective view of a liquid-cooled jacket according to a first embodiment of the present invention;
FIG. 2 is a cross-sectional view of the liquid-cooled jacket according to the first embodiment;
FIG. 3 is a perspective view of a clad member according to the first embodiment;
FIG. 4 perspectively illustrates a first cutting step according to the first embodiment;
FIG. 5 perspectively illustrates a second cutting step according to the first embodiment;
FIG. 6 perspectively illustrates a fin-forming step according to the first embodiment;
FIG. 7 cross-sectionally illustrates an arranging step according to the first embodiment;
FIG. 8 perspectively illustrates a joining step according to the first embodiment;
FIG. 9 cross-sectionally illustrates the joining step according to the first embodiment;
FIG. 10 cross-sectionally illustrates a removing step according to the first embodiment;
FIG. 11 is a perspective view of a liquid-cooled jacket according to a second embodiment of the present invention;
FIG. 12 is a cross-sectional view of the liquid-cooled jacket according to the second embodiment;
FIG. 13 is an exploded perspective view of the liquid- cooled jacket according to the second embodiment;
FIG. 14 perspectively illustrates a first cutting step according to the second embodiment;
FIG. 15 perspectively illustrates a second cutting step according to the second embodiment;
FIG. 16 perspectively illustrates a fin-forming step according to the second embodiment;
FIG. 17 cross-sectionally illustrates an arranging step according to the second embodiment;
FIG. 18 cross-sectionally illustrates a joining step according to the second embodiment;
FIG. 19 is an exploded perspective view of a liquid- cooled jacket according to a third embodiment of the present invention;
FIG. 20 is a cross-sectional view of the liquid-cooled jacket according to the third embodiment;
FIG. 21 is a perspective view of a clad member according to the third embodiment;
FIG. 22 perspectively illustrates a first cutting step according to the third embodiment;
FIG. 23 perspectively illustrates a second cutting step according to the third embodiment;
FIG. 24 perspectively illustrates a fin-forming step according to the third embodiment;
FIG. 25 cross-sectionally illustrates an arranging step according to the third embodiment;
FIG. 26 perspectively illustrates an auxiliary member arranging step according to the third embodiment;
FIG. 27 perspectively illustrates a joining step according to the third embodiment;
FIG. 28 cross-sectionally illustrates the joining step according to the third embodiment;
FIG. 29 cross-sectionally illustrates a removing step according to the third embodiment;
FIG. 30 is a perspective view of a liquid-cooled jacket according to a fourth embodiment of the present invention;
FIG. 31 is a cross-sectional view of the liquid-cooled jacket according to the fourth embodiment;
FIG. 32 is an exploded perspective view of the liquid-cooled jacket according to the fourth embodiment;
FIG 33 perspectively illustrates a first cutting step according to the fourth embodiment;
FIG. 34 perspectively illustrates a second cutting step according to the fourth embodiment;
FIG. 35 perspectively illustrates a fin-forming step according to the fourth embodiment;
FIG. 36 cross-sectionally illustrates an arranging step according to the fourth embodiment;
FIG. 37 cross-sectionally illustrates a joining step according to the fourth embodiment;
FIG. 38 is a cross-sectional view of a first modification; and
FIG. 39 is a cross-sectional view of a second modification.

### Embodiments of the Invention

### [First Embodiment]

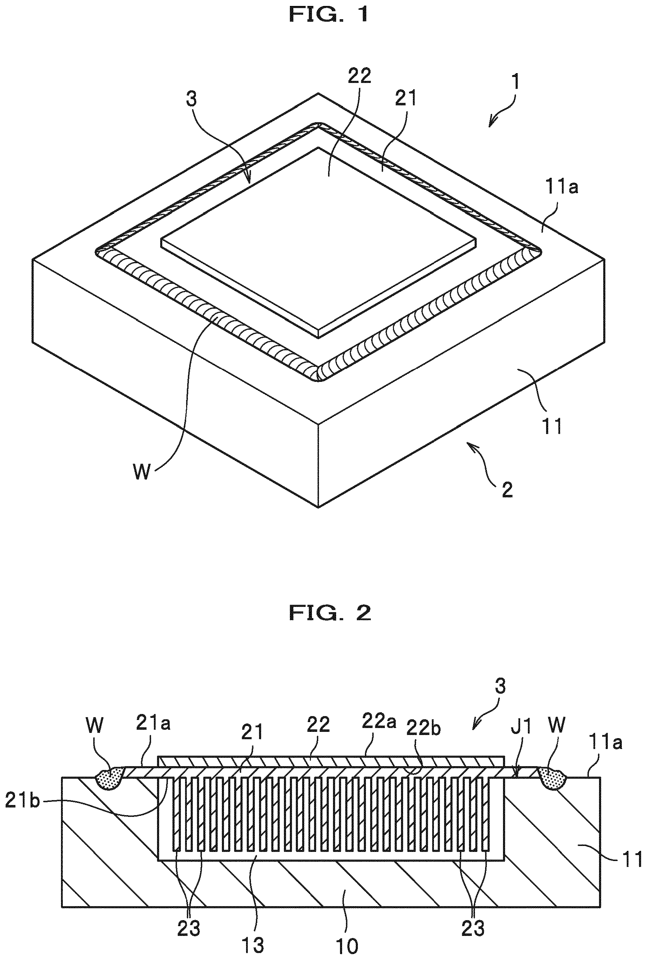

A description will be given of a liquid-cooled jacket and a method for manufacturing the liquid-cooled jacket with reference to the accompanying drawings. As shown in FIG. 1, a liquid-cooled jacket 1 according to the present embodiment has a jacket body 2 and a seal body 3. The liquid-cooled jacket 1 is a device in which a fluid circulates to exchange heat with a heating element (not shown) mounted in the liquid-cooled jacket 1. Note that a "front face" in the following description is meant to be an opposite side of a "rear face".

As shown in FIG. 2, the jacket body 2 includes a bottom 10 and a peripheral wall 11. The jacket body 2 is a box-shaped body and its top is open. The jacket body 2 is, in the present embodiment, made of aluminum alloy. The material of the jacket body 2 is appropriately selected from metals to be stirred frictionally, such as, aluminum, aluminum alloy, copper, copper alloy, titanium, titanium alloy, magnesium and magnesium alloy. The bottom 10 is in a rectangular plate shape in a plan view. The peripheral wall 11 is arranged to extend upward from the peripheral edge of the bottom 10 and is in a rectangular frame shape in a plan view. A recess 13 is delimited inside the bottom 10 and the peripheral wall 11.

The seal body 3 is a plate-shaped member that seals the opening of the jacket body 2. The seal body 3 has a first substrate 21, a second substrate 22 and a plurality of fins 23. The first substrate 21 is slightly smaller than the jacket body 2 in a plate shape. The first substrate 21 is joined by friction stir to the peripheral wall 11 to seal the opening of the jacket body 2. That is, a plasticized region W is formed in an overlaid portion J1 where a rear face 21b of the first substrate 21 is overlaid on an end face 11a of the peripheral wall 11. The plasticized region W is formed on the outer peripheral edge of the seal body 3.

The second substrate 22 is overlaid on a front face 21a of the first substrate to have the peripheral edge of the first substrate 21 exposed. The second substrate 22 has substantially the same thickness as the first substrate 21. The second substrate 22 is slightly smaller than the first substrate 21 in a plate shape.

The fins 23 are arranged to extend downward from the rear face 21b of the first substrate 21. The first substrate 21 and the fins 23 are formed into one piece. The first substrate 21 and the fins 23 in the present embodiment are made of aluminum alloy (first metal). On the other hand, the second substrate 22 in the present embodiment is made of copper alloy (second metal).

The first substrate 21 and the second substrate 22 are made of two different kinds of metals, and the metals are appropriately selected from metals, to be stirred frictionally, such as aluminum, aluminum alloy, copper, copper alloy, titanium, titanium alloy, magnesium and magnesium alloy. A front face 22a of the second substrate 22 is positioned higher than the front face 21a of the first substrate 21 by its own thickness. The heating element (member) may be mounted on the front face 22a of the second substrate 22.

Next, a description will be given of the method for manufacturing the liquid-cooled jacket according to the first embodiment. The method for manufacturing a liquid-cooled jacket includes a preparing step, an arranging step, a joining step and a removing step.

In the preparing step, the jacket body 2 and the seal body 3 are formed. In the preparing step, as shown in FIGS. 1 and 2, the jacket body 2 is formed. A method for forming the jacket body 2 is not particularly limited, but may be formed by, for example, die-casting. Further, the preparing step includes a clad member forming step, a first cutting step, a second cutting step and a fin-forming step, to form the seal body 3.

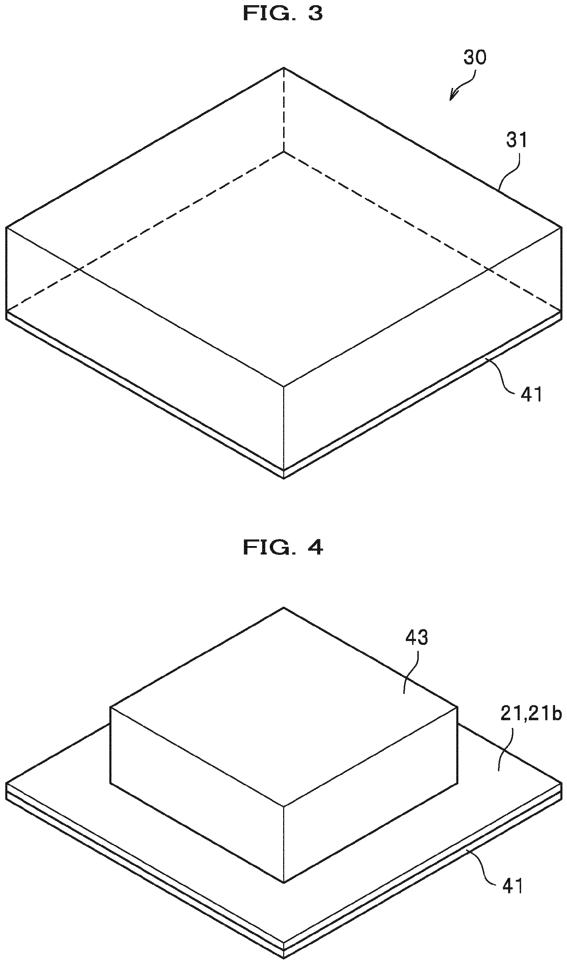

In the clad member forming step, a clad member 30 shown in FIG. 3 is formed. The clad member 30 is formed with a first base 31 and a second base 41. The first base 31 is made of the first metal (aluminum alloy in the present embodiment) and is in a rectangular parallelepiped shape. The second base 41 is made of the second metal (copper alloy in the present embodiment) and is in a plate shape. The second base 41 has the same plate shape as the first base 31. The clad member 30 is formed by overlaying a raw material made of the first metal on a raw material made of the second metal so as to be rolled and by cutting into a given size.

As shown in FIG. 4, in the first cutting step, a portion of the first base 31 (see FIG. 3) is cut off to form the first substrate 21 and a block 43. In the first cutting step, the first base 31 is cut with a cutting machine or the like. With the step, the plate-shaped first substrate 21 is formed, and the block 43 in a rectangular parallelepiped shape is formed on the center of the rear face 21b of the first substrate 21.

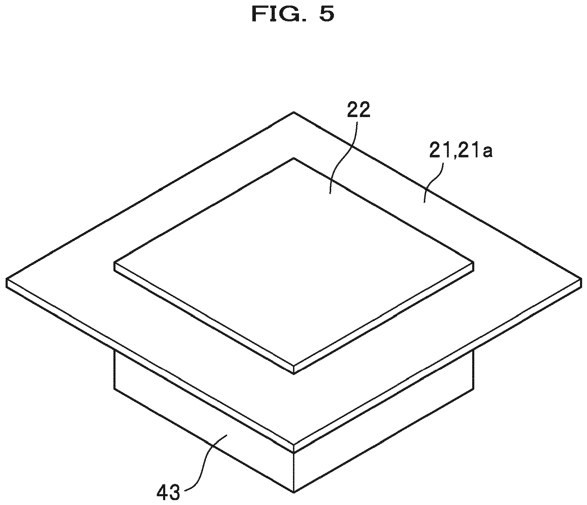

As shown in FIG. 5, in the second cutting step, a portion of the second base 41 (see FIG. 4) is cut off to form the second substrate 22. In the second cutting step, the second base 41 is cut with the cutting machine or the like to form the second substrate 22 so as to have the peripheral edge of the first substrate 21 exposed. Accordingly, the second substrate 22 is formed on the center of the front face 21a of the first substrate 21.

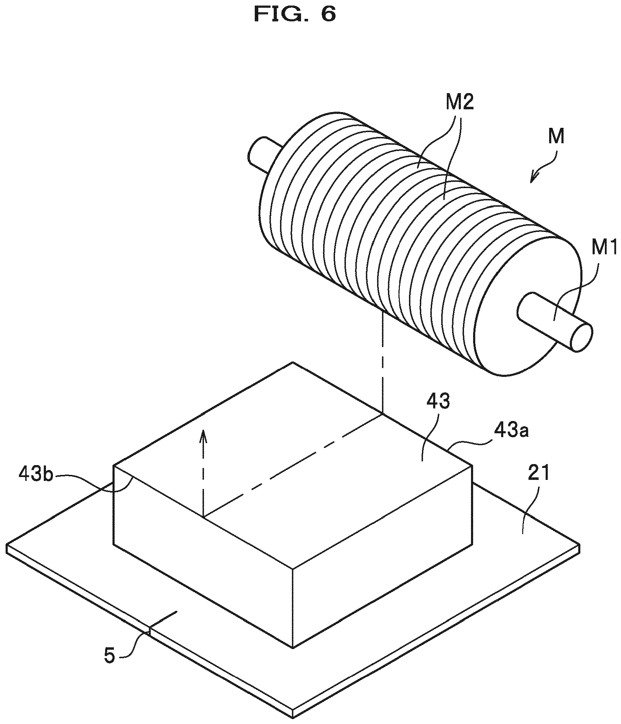

As shown in FIG. 6, in the fin-forming step, the block 43 is cut into the fins 23 (see FIG. 2) with a multi-cutter M. The multi-cutter M is a rotary tool for cutting a member. The multi-cutter M has a shaft M1 and a plurality of disc cutters M2 arranged in parallel on the shaft M1 at intervals. A cutting blade (not shown) is formed on the periphery of each disc cutter M2. The intervals and thickness of the fins 23 are appropriately set by controlling the thickness and intervals of the disc cutters M2.

In the fin-forming step, the shaft M1 of the multi-cutter M is arranged in parallel with one side 43a of the block 43 and the disc cutters M2 of the rotating multi-cutter M are inserted in the block 43. When the disc cutters M2 reach a given depth, the multi-cutter M is moved horizontally to the other side 43b facing the one side 43a. When the shaft M1 reaches the other side 43b, the multi-cutter M is relatively moved away from the block 43.

The insertion depth of the multi-cutter M may be appropriately set, and, in the present embodiment, it may be controlled such that the disc cutters M2 do not reach the first substrate 21, that is, an uncut region remains in the block 43. Further, in the fin-forming step, a slit 5 is formed that extends toward the center from the outer edge of the first substrate 21. Note that the first cutting step, the second cutting step and the fin-forming step are not limited in the order described above.

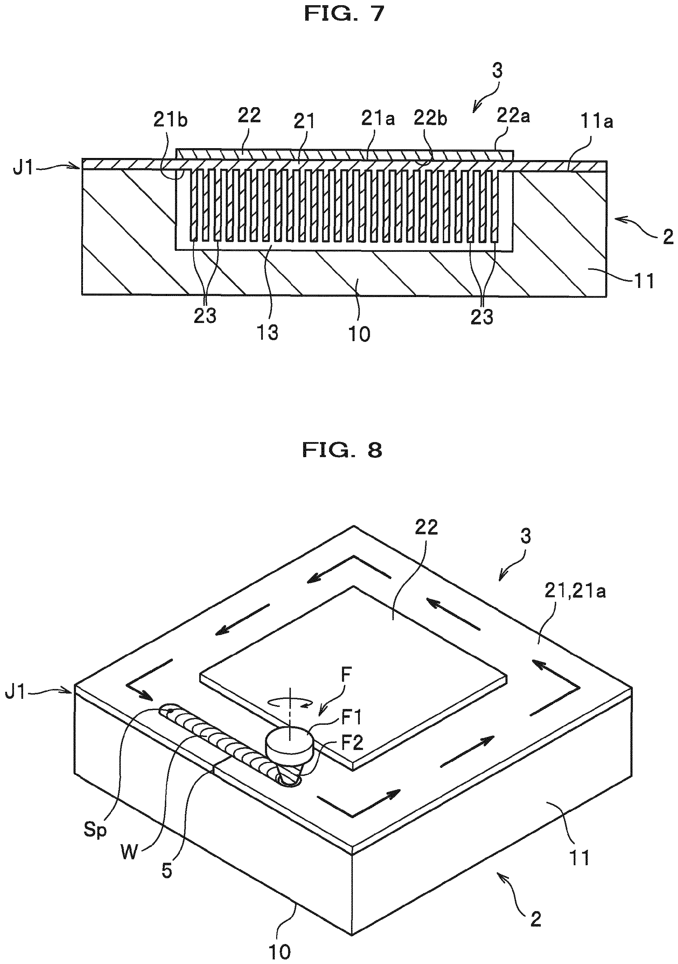

In the arranging step, the seal body 3 is arranged on the jacket body 2 to form the overlaid portion J1. As shown in FIG. 7, in the arranging step, the seal body 3 is arranged on the end face 11a of the peripheral wall 11 to overlay the rear face 21b of the first substrate 21 on the end face 11a of the peripheral wall 11. Thus, the overlaid portion J1 is formed at the peripheral edge of the seal body 3. Further, the jacket body 2 and the seal body 3 are immovably fixed on a table with a fixing jig such as a clamp.

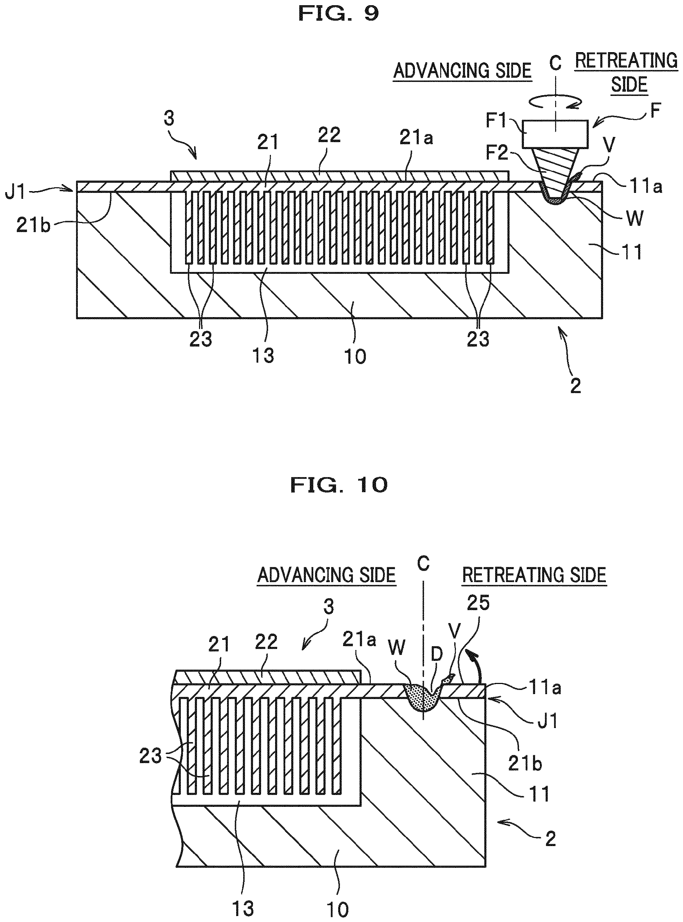

In the joining step, as shown in FIGS. 8 and 9, joining rotary tool F is used to join the seal body 3 on the jacket body 2 by friction stir. In the joining step of the present embodiment, the joining rotary tool F is used to apply friction stir joining to the overlaid portion J1.

The joining rotary tool F has a coupling portion F1 and a stirring pin F2. The joining rotary tool F corresponds to a "rotary tool" in the appended claims. The joining rotary tool F is made of, for example, tool steel. The coupling portion F1 is connected to a rotation shaft of a friction stir device. The coupling portion F1 is in a cylindrical shape.

The stirring pin F2 extends vertically downward from the coupling portion F1 so as to be coaxially arranged therewith. The stirring pin F2 tapers off with the increasing distance from the coupling portion F1. The length of the stirring pin F2 is greater than the thickness of the first substrate 21. A spiral groove is threaded on the outer peripheral face of the stirring pin F2. In the present embodiment, since the joining rotary tool F is rotated clockwise, the spiral groove is formed counterclockwise as it extends from the base end toward the tip end.

Note that, in a case where the joining rotary tool F is rotated counterclockwise, the spiral groove is preferably formed clockwise from the base end toward the tip end. The spiral groove formed in this way allows plastically fluidized metal to be led toward the tip end of the stirring pin F2 via the spiral groove during friction stir. This reduces the amount of metal overflowing out of the joined metal members (jacket body 2 and seal body 3).

In the joining step, the stirring pin F2 of the joining rotary tool F in clockwise rotation is inserted in a start position Sp set on the front face 21a of the first substrate 21 and the joining rotary tool F is relatively moved. In the present embodiment, since the joining rotary tool F is rotated clockwise, the spiral groove of the stirring pin F2 is formed counterclockwise as it extends from the base end toward the tip end. The plasticized region W is formed on the trace on which the joining rotary tool F has moved. In the joining step, the joining rotary tool F is relatively moved around the second substrate 22 to form the plasticized region W in a rectangular closed loop in a planar view. The joining rotary tool F may be moved in either direction. In the present embodiment, the joining rotary tool F is set to move counterclockwise with respect to the second substrate 22. In doing so, the joining rotary tool F is preferably moved such that the plasticized region W contacts an inner end of the slit 5.

As shown in FIG. 9, in the joining step, friction stir joining is applied in a state where the coupling portion F1 is not brought in contact with the first substrate 21, that is, in a state where the base end of the stirring pin F2 is exposed. The insertion depth of the joining rotary tool F may be suitably set, and, in the present embodiment, friction stir joining is applied such that the stirring pin F2 reaches the peripheral wall 11, that is, the stirring pin F2 is in contact with the peripheral wall 11 and the first substrate 21.

Note that, in a case where the stirring pin F2 does not reach the peripheral wall 11, that is, the stirring pin F2 only contacts the first substrate 21, the overlaid portion J1 is plastically fluidized and is joined by frictional heat between the first substrate 21 and the stirring pin F2.

In the present embodiment, the moving direction and the rotating direction of the joining rotary tool F are set such that a shear side (an advancing side on which a moving speed of the rotary tool is added to a tangential speed on the circumference of the rotary tool) of the joining rotary tool F corresponds to the inner side of the first substrate 21. The moving direction and the rotating direction of the joining rotary tool F are not limited to those described above and may be set as appropriate.

For example, in a case where the rotational speed of the joining rotary tool F is slow, the temperature of the plastically fluidized material increases on the shear side more than on a flow side (retreating side on which the moving speed is subtracted from the tangential speed on the circumference of the rotary tool) of the plasticized region W, to form a recessed groove on the shear side of the inside of the plasticized region W. Therefore, the burrs V tend to be generated more on the shear side of the outside of the plasticized region W. On the other hand, for example, in a case where the rotational speed of the joining rotary tool F is fast, though the temperature of the plastically fluidized material rises more on the shear side, the high rotational speed causes the recessed groove to be formed on the flow side of the inside of the plasticized region W. Therefore, the burrs V tend to be generated more on the flow side of the outside of the plasticized region W.

In the present embodiment, since the rotational speed of the joining rotary tool F is set to be fast, as shown in FIG. 10, a recessed groove D is formed on the flow side of the inside of the plasticized region W, and more burrs V tend to be generated on the flow side of the outside of the plasticized region W. The recessed groove D is a portion to be formed deeper in the plasticized region W. Further, the rotational speed of the joining rotary tool F is set to be fast, to increase the moving speed (feeding speed) of the joining rotary tool F. This shortens a joining cycle.

In the joining step, it depends on a joining condition on which side of the moving path of the joining rotary tool F the burrs V are generated. The joining condition is determined by each factor such as the rotational speed, rotational direction and moving speed (feeding speed) of the joining rotary tool F, the inclination angle (taper angle) of the stirring pin F2, the materials of the jacket body 2 and the first substrate 21, and the thickness of the first substrate 21 and combinations thereof. According to the joining condition, if the side where the burrs V are generated or are generated more is set to be closer to the outer edge of the first substrate 21, the recessed groove D formed in the plasticized region W also tends to be formed outside the first substrate 21. The above setting is preferably made because the removing step to be described later is easily executed.

In the joining step, the joining rotary tool F is moved around and is disengaged in the plasticized region W. In the joining step, a start point of the plasticized region W is overlapped with an end point.

As shown in FIG. 10, in the removing step, a redundant portion 25 as a portion of the first substrate 21 is removed. The redundant portion 25 is a portion of the first substrate 21 to be cut off along the plasticized region W as the boundary. In the present embodiment, the portion located outer than the recessed groove D formed in the first substrate 21 is defined as the redundant portion 25.

In the removing step, the end of the redundant portion 25 is turned up at the slit 5 (see FIG. 8) and folded toward the center of the first substrate 21 to remove the redundant portion 25. In the removing step, the redundant portion 25 may be folded by a device, but, in the present embodiment, is folded manually. Accordingly, the liquid-cooled jacket 1 shown in FIG. 1 is manufactured.

According to the method for manufacturing a liquid-cooled jacket and the liquid-cooled jacket 1 as described above, the jacket body 2 is joined by friction stir with the seal body 3 to increase the water-tightness and air-tightness. Further, the seal body 3 is formed to have the peripheral edge of the first substrate 21 exposed and friction stir joining is applied to the peripheral edge, to prevent the first metal (aluminum alloy) from being mixed with the second metal (copper alloy) at the time of friction stir joining. That is, since the influence of the second metal can be omitted at the time of joining step, the joining condition is easily set for friction stir joining.

Further, the seal body 3 may be formed by any method, but is easily formed by the first cutting step, the second cutting step and the fin-forming step. Also, as in the present embodiment, only the stirring pin F2 is brought in contact with the peripheral wall 11 and the first substrate 21 for friction stir, to allow the overlaid portion J1 at a deep position to be joined by friction stir without a large load applied on the friction stir device.

Here, in a case where a shoulder is brought in contact with the first substrate 21 as in the prior art, the width of the peripheral wall 11 must be formed larger to prevent the plastically fluidized material from flowing into the liquid-cooled jacket 1. However, as in the present embodiment, only the stirring pin F2 is brought in contact with the peripheral wall 11 and the first substrate 21 for friction stir, to allow for reducing the width of the plasticized region W. This reduces the width of the peripheral wall 11 to increase flexibility in design.

Further, as in the joining step according to the present embodiment, the joining condition is set such that the burrs V are generated on an outer side of the first substrate 21, to allow the burrs V generated by friction stir joining to be easily removed with the redundant portion 25.

Further, as shown in FIG. 10, according to the present embodiment, the recessed groove D is formed in the plasticized region W and outside a joining centerline C (outer side of the first substrate 21). Still further, since the burrs V are generated outside the plasticized region W and outside the joining centerline C, the burrs V are effectively cut off with the redundant portion 25. This makes the redundant portion 25 to be cut off smaller and causes the joined portion (plasticized region W) to be largely kept, to enhance the joining strength. Yet further, the redundant portion 25 is easily folded because of the recessed groove D, and the joined portion (plasticized region W) is clearly finished without a burr removing work separately.

Furthermore, the materials of the first substrate 21 and the second substrate 22 are not particularly limited, but, as in the present embodiment, the first substrate 21 may be made of aluminum alloy (first metal) and the second substrate 22 mounted with the heating element may be made of copper alloy (second metal), to enhance the heat conductivity.

### [Second Embodiment]

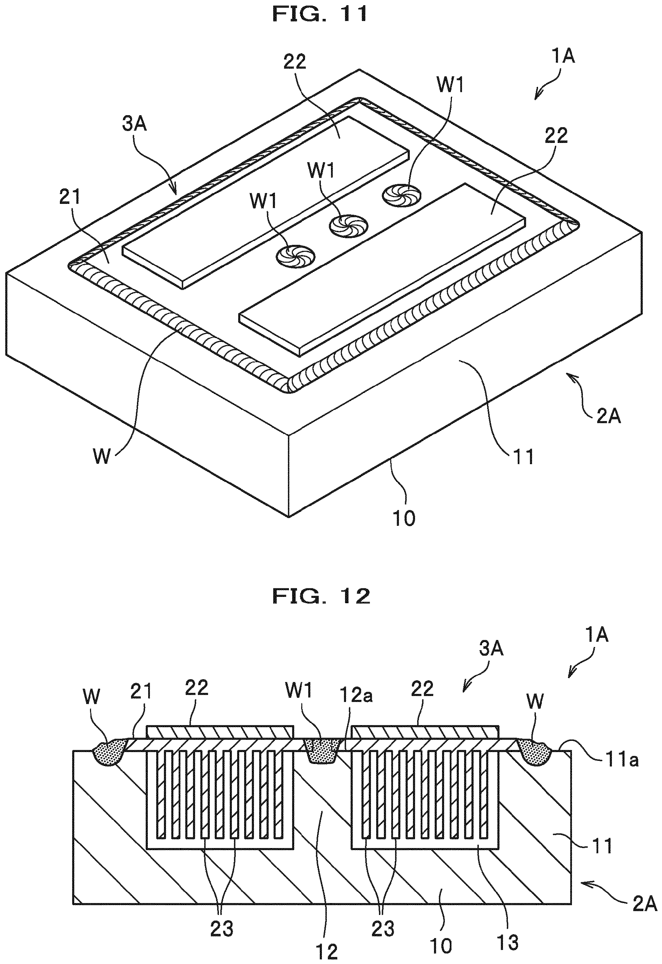

A description will be given of a liquid-cooled jacket and a method for manufacturing the liquid-cooled jacket according to a second embodiment of the present invention. As shown in FIGS. 11 and 12, a liquid-cooled jacket 1A according to the second embodiment has a jacket body 2A and a seal body 3A. The liquid-cooled jacket 1A is different from the first embodiment on the point that a support 12 is formed. Portions in the second embodiment different from those in the first embodiment will be mainly described.

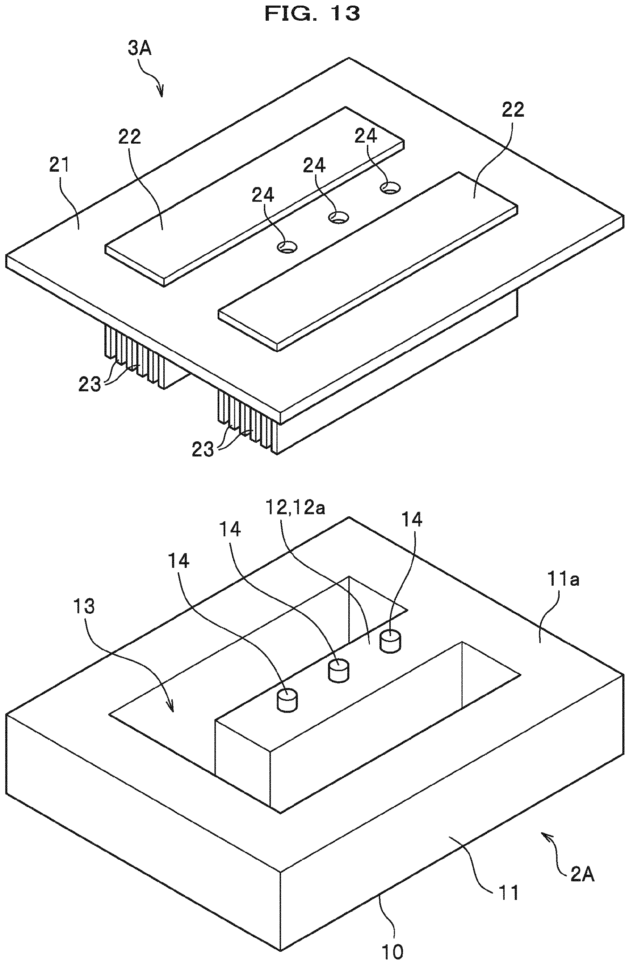

As shown in FIGS. 12 and 13, the jacket body 2A includes a bottom 10, a peripheral wall 11 and the support 12. The support 12 is a plate-shaped member that is formed to vertically extend upward from the bottom 10. The support 12 is formed continuously to one wall of the peripheral wall 11 and is spaced apart from the other wall that faces the one wall. An end face 12a of the support 12 is flush with an end face 11a of the peripheral wall 11. Protrusions 14 are formed on the end face 12a of the support 12. The protrusions 14 have approximately the same height as the thickness of a first substrate 21. The protrusions 14 may have any shape and are in a cylindrical shape in the present embodiment. The number of protrusions 14 is not particularly limited and three protrusions are formed in the present embodiment.

As shown in FIG. 13, the seal body 3A has the first substrate 21, second substrates 22, a plurality of fins 23, and three holes 24. The pair of second substrates 22 is formed on both sides of the holes 24. The fins 23 are formed at positions corresponding to the second substrates 22. That is, the fins 23 are not formed in an area where the holes 24 are formed and the vicinity thereof. The holes 24 are formed to penetrate the central portion of the first substrate 21 in the thickness direction. The holes 24 are formed to have a size in which the protrusions 14 are inserted without clearance.

Next, a description will be given of the method for manufacturing the liquid-cooled jacket according to the second embodiment. The method for manufacturing a liquid-cooled jacket includes a preparing step, an arranging step, a joining step and a removing step.

In the preparing step, the jacket body 2A and the seal body 3A are formed. The preparing step includes a clad member forming step, a first cutting step, a second cutting step and a fin-forming step, to form the seal body 3A. The clad member forming step is the same as that in the first embodiment to form the clad member 30 described in FIG. 3.

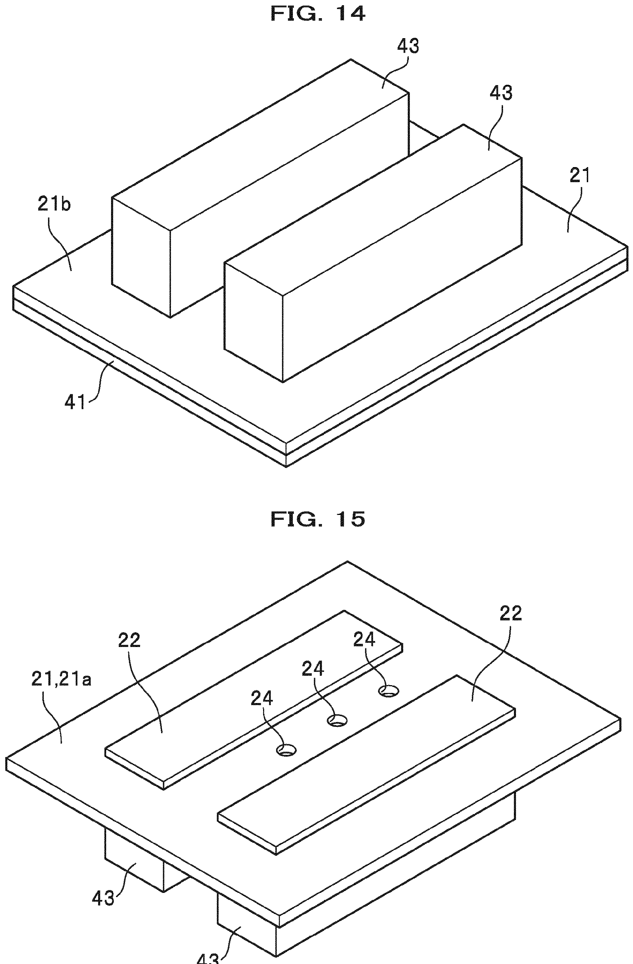

As shown in FIG. 14, in the first cutting step, a portion of the first base 31 (see FIG. 3) is cut off to form the first substrate 21 and blocks 43. In the first cutting step, the first base 31 is cut with a cutting machine or the like. With this step, the plate-shaped first substrate 21 is formed, and the blocks 43 are formed on a rear face 21b of the first substrate 21.

As shown in FIG. 15, in the second cutting step, a portion of a second base 41 (see FIG. 14) is cut off to form the second substrates 22. In the second cutting step, the peripheral edge and the central portion of the second base 41 are cut off with the cutting machine or the like to form the second substrates 22 so as to have the peripheral edge and the central portion of the first substrate 21 exposed. Accordingly, the second substrates 22 apart from each other are formed on a front face 21a of the first substrate 21. Further, in the second cutting step, the three penetrating holes 24 are formed at the central portion of the first substrate 21.

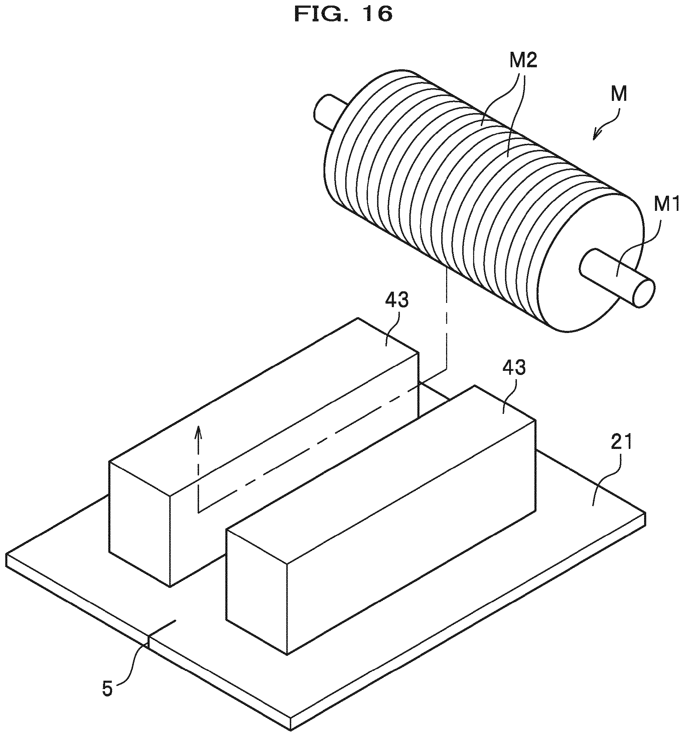

As shown in FIG. 16, in the fin-forming step, the blocks 43 are cut into the fins 23 (see FIG. 12) with a multi-cutter M. The fin-forming step is the same as that in the first embodiment to form the fins 23. Further, in the fin-forming step, a slit 5 is formed that extends from the outer edge toward the central portion of the first substrate 21.

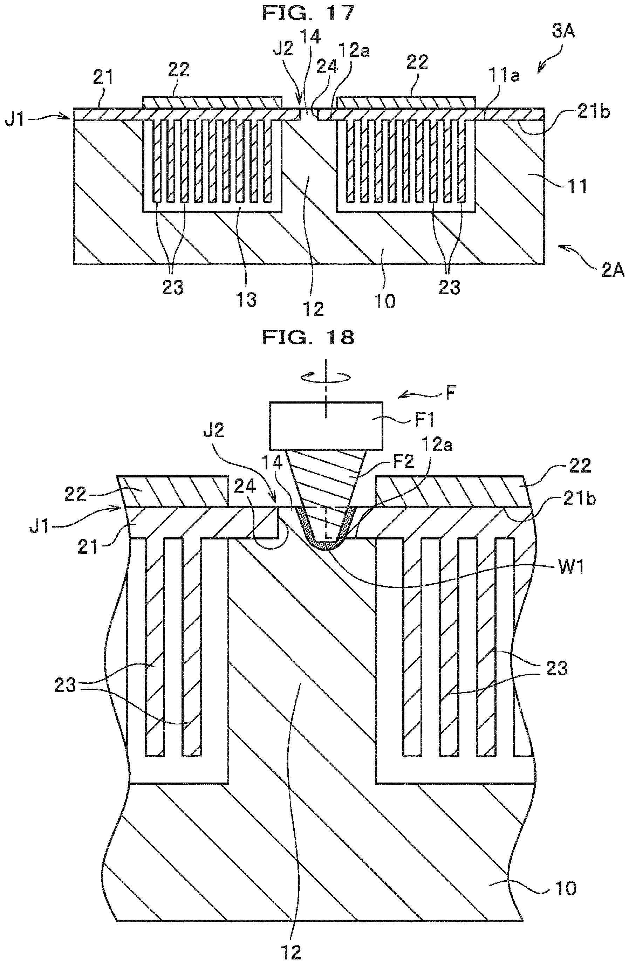

In the arranging step, the seal body 3A is arranged on the jacket body 2A to form an overlaid portion J1 and a butted portion J2. As shown in FIG. 17, in the arranging step, the seal body 3A is arranged on the end face 11a of the peripheral wall 11 to overlay the rear face 21b of the first substrate 21 on the end face 11a of the peripheral wall 11. Thus, the overlaid portion J1 is formed along the peripheral edge of the seal body 3A. Further, the protrusions 14 are inserted in the holes 24 to form the butted portion J2 where the outer periphery of each protrusion 14 is in contact with the wall of each hole 24. Still further, the jacket body 2A and the seal body 3A are immovably fixed on a table with a fixing jig such as a clamp.

As shown in FIG. 18, the joining step includes a first joining step and a second joining step with a joining rotary tool F. The first joining step is the same as the joining step in the first embodiment, and the description thereof is omitted. In the second joining step, the butted portion J2 is joined by friction stir. The first joining step may be done prior to the second joining step, but is done vice versa in the present embodiment.

In the second joining step, the rotating joining rotary tool F is moved along the entire butted portion J2 for joining. The joining rotary tool F may be inserted such that the stirring pin F2 does not reach the end face 12a of the support 12, but, in the present embodiment, the stirring pin F2 is made to contact the end face 12a of the support 12 to further join by friction stir the overlaid portion between the end face 12a and the rear face 21b of the first substrate 21.

The removing step is the same as that in the first embodiment, and the description thereof is omitted. Accordingly, the liquid-cooled jacket 1A shown in FIGS. 11 and 12 is formed.

The method for manufacturing a liquid-cooled jacket and the liquid-cooled jacket 1A described above also provide the same advantageous effects as the first embodiment. Further, since the protrusions 14 formed on the support 12 are inserted in the holes 24 formed in the seal body 3A, the seal body 3A is easily positioned. Further, the support 12 is joined to the seal body 3A to increase the strength of the liquid-cooled jacket 1A.

Here, in a case where a shoulder is brought in contact with the protrusions 14 and the first substrate 21 as in the prior art, the width of the support 12 must be formed larger so as to prevent the plastically fluidized material from flowing into the liquid-cooled jacket 1A. However, as in the present embodiment, only the stirring pin F2 is brought in contact with the protrusions 14 and the first substrate 21 for friction stir, to allow for reducing the width of a plasticized region W1. Since the width of the support 12 is reduced, the liquid-cooled jacket 1A has more flexibility in design.

In the joining step, a rotary tool having a shoulder and a stirring pin may be used for friction stir joining in a state that the shoulder is pressed against the first substrate 21. Further, the rotary tool may be used to apply friction stir joining to the overlaid portion J1 with only the stirring pin F2 to be brought in contact with only the first substrate 21, or with both the first substrate 21 and the peripheral wall 11. Further, in the present embodiment, the fins 23 are formed in the seal body 3, but the fins 23 may not be formed in the liquid-cooled jacket.

### [Third Embodiment]

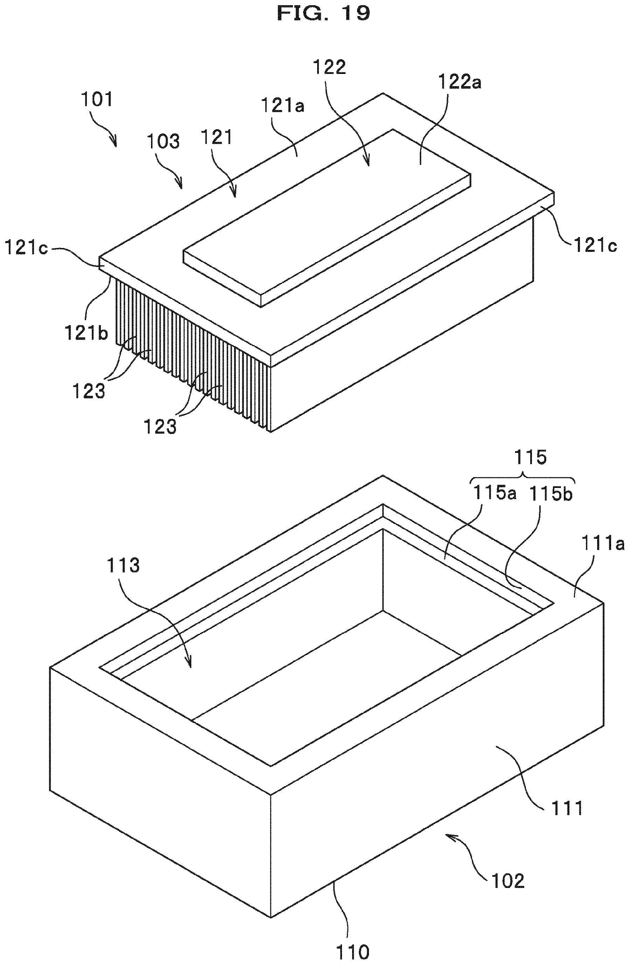

A description will be given in detail of a liquid-cooled jacket and a method for manufacturing the liquid-cooled jacket according to a third embodiment of the present invention with reference to the drawings. As shown in FIG. 19, a liquid-cooled jacket 101 according to the present embodiment has a jacket body 102 and a seal body 103. A fluid circulates in the liquid-cooled jacket 101 and exchanges heat with a heat element (not shown) mounted in the liquid-cooled jacket 101.

The jacket body 102 includes a bottom 110 and a peripheral wall 111. The jacket body 102 is a box-shaped body of which its top face is open. The jacket body 102 is, in the present embodiment, made of aluminum alloy. The material of the jacket body 102 is selected from friction stirrable metals such as aluminum, aluminum alloy, copper, copper alloy, titanium, titanium alloy, magnesium, and magnesium alloy. The bottom 110 is in a rectangular plate shape in a planar view. The peripheral wall 111 is formed to vertically extend upward from the peripheral edge of the bottom 110 and is in a rectangular frame shape in a planar view. A recess 113 is defined by the bottom 110 and the peripheral wall 111.

At the inner peripheral edge of the peripheral wall 111, a stepped portion 115 is formed. The stepped portion 115 includes a stepped bottom face 115a and a stepped side face 115b that is formed to vertically rise from the stepped bottom face 115a. The stepped bottom face 115a is formed at a position one step lower than an end face 111a of the peripheral wall 111.

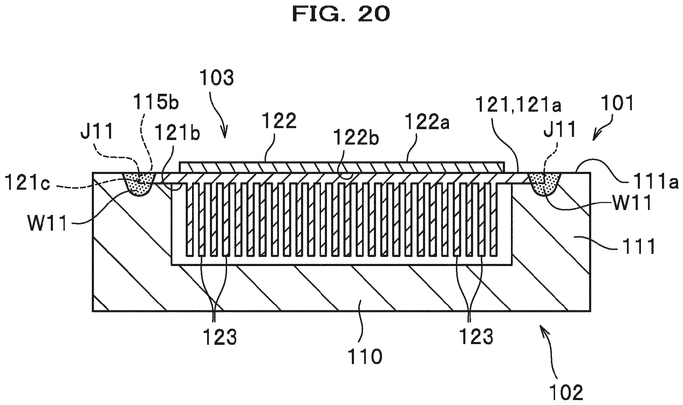

The seal body 103 is a plate-shaped member that seals the opening of the jacket body 102. The seal body 103 has a first substrate 121, a second substrate 122 and a plurality of fins 123. The first substrate 121 is slightly smaller than the jacket body 102 in a plate shape. As shown in FIG. 20, the first substrate 121 seals the opening of the jacket body 102 and is joined by friction stir to the peripheral wall 111. That is, a plasticized region W11 is formed at a first butted portion J11 where side face 121c of the first substrate 121 is butted on the stepped side face 115b.

The second substrate 122 is overlaid on a front face 121a of the first substrate 121 so as to have the peripheral edge of the first substrate 121 exposed. The thickness of the second substrate 122 is substantially the same as that of the first substrate 121. The second substrate 122 is slightly smaller than the first substrate 121 in a plate shape.

The fins 123 are arranged to vertically extend downward from a rear face 121b of the first substrate portion 121. The first substrate 121 and the fins 123 are formed into one piece. The first substrate 121 and the fins 123 are, in the present embodiment, made of aluminum alloy (first metal), while the second substrate 122 is, in the present embodiment, made of copper alloy (second metal).

The first substrate 121 and the second substrate 122 are made of two different kinds of metals, and are appropriately selected from friction stirrable metals such as aluminum, aluminum alloy, copper, copper alloy, titanium, titanium alloy, magnesium, and magnesium alloy. A front face 122a of the second substrate 122 is positioned higher than the front face 121a of the first substrate 121 by the thickness of the second substrate 122. The front face 122a of the second substrate 122 may be used, for example, to mount thereon the heating element (component).

Next, a description will be given of the method for manufacturing the liquid-cooled jacket according to the third embodiment. The method for manufacturing a liquid-cooled jacket includes a preparing step, a seal body arranging step, an auxiliary member arranging step, a joining step, and a removing step.

In the preparing step, the jacket body 102 and the seal body 103 are formed. The jacket body 102 is formed in a box shape having the bottom 110 and the peripheral wall 111, for example, by die casting, and the stepped portion 115 is formed by cutting the inner peripheral edge of the peripheral wall 111.

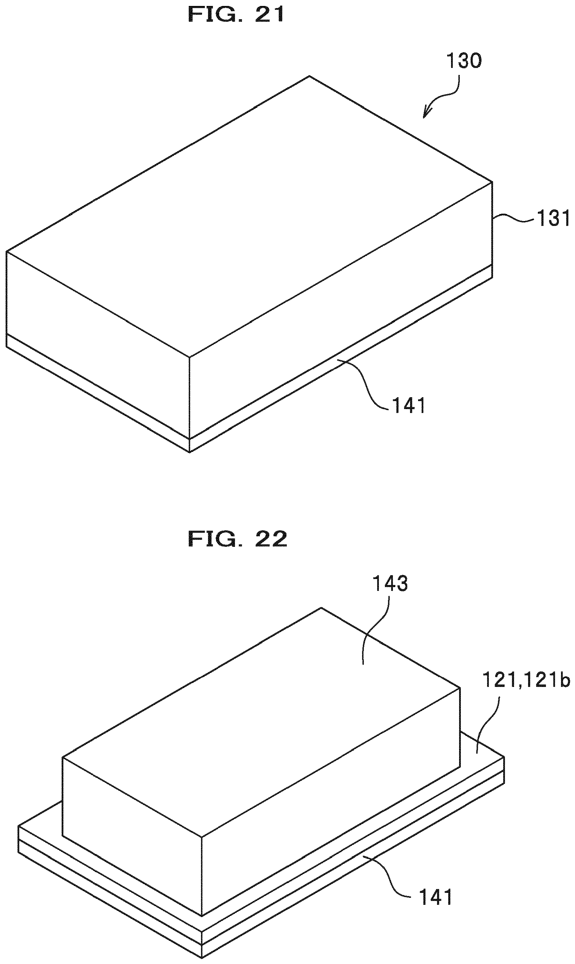

Further, the preparing step includes a clad member forming step, a first cutting step, a second cutting step and a fin-forming step, to form the seal body 103. In the clad member forming step, a clad member 130 shown in FIG. 21 is formed. The clad member 130 includes a first base 131 and a second base 141. The first base 131 is made of a first metal (aluminum alloy in the present embodiment) in a rectangular parallelepiped shape. The second base 141 is made of a second metal (copper alloy in the present embodiment) in a plate shape. The second base 141 is identical to the first base 131 in a plate shape. A raw material made of the first metal is overlaid on a raw material made of the second metal so as to be rolled and is cut off in a given size for forming the clad member 130.

As shown in FIG. 22, in the first cutting step, a portion of the first base 131 (see FIG. 21) is cut off to form the first substrate 121 and a block 143. In the first cutting step, the first base 131 is cut with a cutting machine or the like. With this step, the plate-shaped first substrate 121 is formed, and the block 143 in a rectangular parallelepiped shape is formed at the center of the rear face 121b of the first substrate 121.

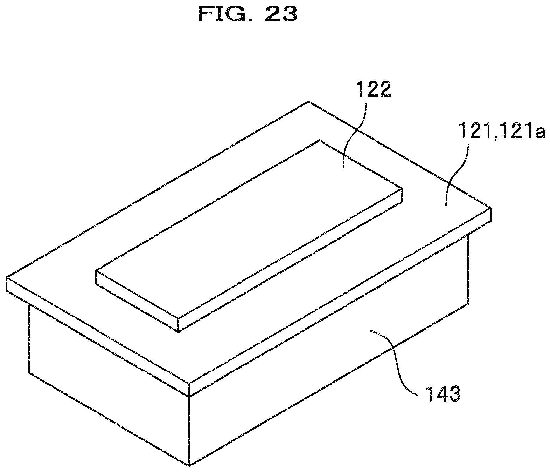

As shown in FIG. 23, in the second cutting step, a portion of the second base 141 (see FIG. 22) is cut off to form the second substrate 122. In the second cutting step, the second base 141 is cut with a cutting machine or the like to form the second substrate 122 so as to have the peripheral edge of the first substrate 121 exposed. Accordingly, the second substrate 122 is formed at the center of the front face 121a of the first substrate 121.

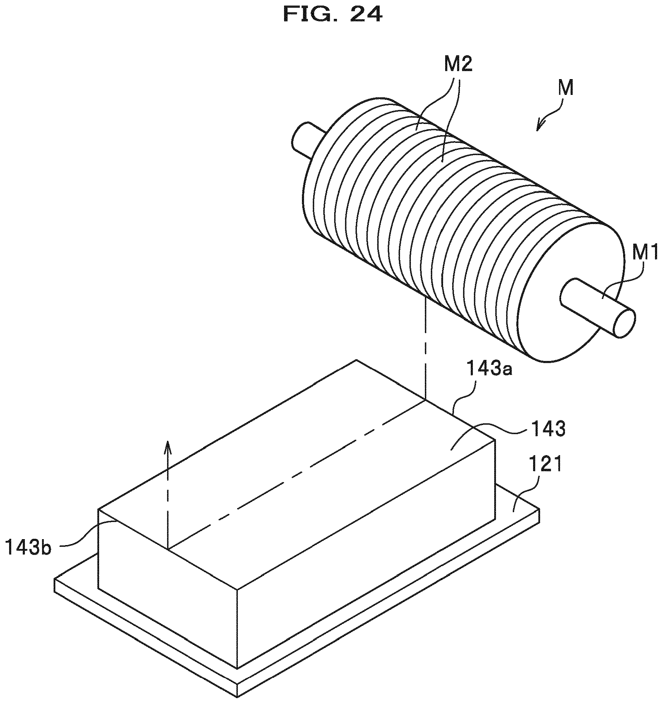

As shown in FIG. 24, in the fin-forming step, the block 143 is cut into the fins 23 (see FIG. 20) with a multi-cutter M. The intervals and thickness of the fins 123 are appropriately set by adjusting the thickness and intervals of disc cutters M2.

In the fin-forming step, a shaft M1 of the multi-cutter M is arranged in parallel to one side 143a of the block 143 and the disc cutters M2 of the rotating multi-cutter M are inserted into the block 143. When the disc cutters M2 reach a given depth, the multi-cutter M is moved horizontally to the other side 143b facing the one side 143a. When the shaft M1 reaches the other side 143b, the multi-cutter M is relatively moved away from the block 143.

The insertion depth of the multi-cutter M may be appropriately set, and, in the present embodiment, it may be controlled such that the disc cutters M2 do not reach the first substrate 121, that is, an uncut region remains in the block 143. Note that, in the present embodiment, the first cutting step, the second cutting step and the fin-forming step are executed in the order described above, but the order is not limited thereto.

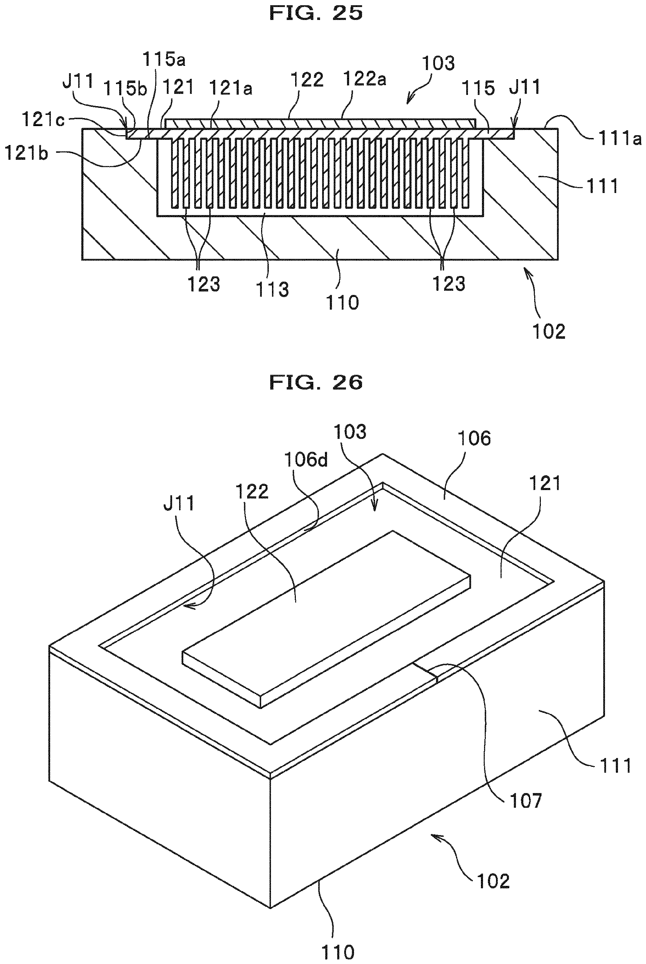

In the seal body arranging step, the seal body 103 is arranged on the jacket body 102 to form the first butted portion J11. As shown in FIG. 25, in the seal body arranging step, the first substrate 121 is arranged on the stepped portion 115. Accordingly, the first butted portion J11 is formed at which the stepped side face 115b of the stepped portion 115 is butted with the side face 121c of the first substrate 121. The first butted portion J11 is formed along the inner peripheral edge of the peripheral wall 111.

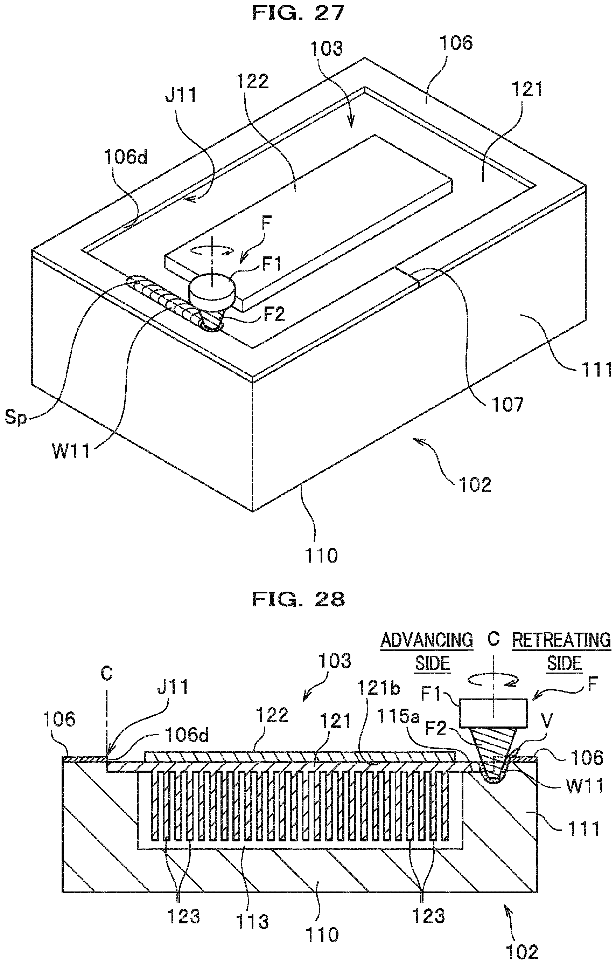

As shown in FIG. 26, in the auxiliary member arranging step, an auxiliary member 106 is arranged along the first abutted portion J11. The auxiliary member 106 is a plate-shaped member in a rectangular frame shape in a planar view. The auxiliary member 106 may be made of any material as long as it is a friction stirrable metal, and, in the present embodiment, the auxiliary member 106 is made of the same material as the first substrate 121. The auxiliary member 106 has a size of an inner peripheral face 106d (also see FIG. 28) thereof overlaying the first butted portion J11. The thickness of the auxiliary member 106 may be appropriately set to an extent such that the plasticized region W11 is not in short supply of metal during the joining step described later.

Further, in the present embodiment, the inner peripheral face 106d of the auxiliary member 106 is positioned to overlay the first butted portion J11, but may be positioned to be inner or outer than the first butted portion J11. The position of the inner peripheral face 106d of the auxiliary member 106 is preferably set to such an extent that the plasticized region W11 is not in short supply of metal at the time of the joining step to be described later, and the auxiliary member 106 does not remain on the peripheral wall 111 after the removing step to be described later.

A slit 107 is formed in the auxiliary member 106 to extend in the width direction. Further, the jacket body 102, the seal body 103 and the auxiliary member 106 are immovably fixed on a table with a fixing jig such as a clamp.

As shown in FIGS. 27 and 28, in the joining step, the jacket body 102, the seal body 103 and the auxiliary member 106 are joined by friction stir with the joining rotary tool F. In the joining step of the present embodiment, the joining rotary tool F is used to apply friction stir joining to the first butted portion J11.

The joining rotary tool F includes a coupling portion F1 and a stirring pin F2. The length of the stirring pin F2 is larger than the thickness of the first substrate 121. A spiral groove is threaded on the outer peripheral face of the stirring pin F2. In the present embodiment, since the joining rotary tool F is rotated clockwise, the spiral groove is formed counterclockwise as it extends from the base end toward the tip end.

Note that, in a case where the joining rotary tool F is rotated counterclockwise, the spiral groove is preferably formed clockwise as it extends from the base end toward the tip end. The spiral groove formed in this way allows plastically fluidized metal to be led toward the tip end of the stirring pin F2 via the spiral groove during friction stirring. This reduces the amount of metal overflowing out of the joined metal members (jacket body 2, seal body 103 and auxiliary member 106).

In the joining step, the stirring pin F2 of the joining rotary tool F in clockwise rotation is inserted in a start position Sp set on the first butted portion J11 and is relatively moved so as to trace the first butted portion J11. In the present embodiment, since the joining rotary tool F is rotated clockwise, the spiral groove of the stirring pin F2 is formed counterclockwise as it extends from the base end to the tip end. The plasticized region W11 is formed in the trace on which the joining rotary tool F has moved. In the joining step, the joining rotary tool F is relatively moved around the second substrate 122 so as to make a closed loop of the plasticized region W11. The joining rotary tool F may be moved in either direction, but in this embodiment, is set to rotate counterclockwise with respect to the second substrate 122. At this time, since the stirring pin F2 is brought in contact with the inner peripheral face 106d of the auxiliary member 106, the peripheral wall 111, the first substrate 121 and the auxiliary member 106 are joined by friction stir simultaneously.

As shown in FIG. 28, in the joining step, friction stir joining is applied in a state where the coupling portion F1 does not contact the first substrate 121 and the auxiliary member 106, that is, the base end of the stirring pin F2 is exposed. The insertion depth of the joining rotary tool F may be suitably set, and in the present embodiment, the stirring pin F2 is inserted to reach the stepped bottom face 115a for friction stir joining. Thus, in addition to the first abutting portion J11, the overlaid portion of the stepped bottom face 115a and the rear face 121b of the first substrate 121 is also joined by friction stir.

In the present embodiment, a moving direction and a rotating direction of the joining rotary tool F are set in such a way that a shear side (an advancing side on which a moving speed of the rotary tool is added to a tangential speed on the circumference of the rotary tool) of the joining rotary tool F corresponds to the inner side of the first substrate 121. The rotating direction and the moving direction of the joining rotary tool F are not limited to those mentioned above, and may be set as appropriate.

For example, in a case where the rotational speed of the joining rotary tool F is slow, the temperature of the plastically fluidized material increases on the shear side more than on a flow side (retreating side on which the moving speed is subtracted from the tangential speed on the circumference of the rotary tool) of the plasticized region W11, to form a recessed groove on the shear side of the inside of the plasticized region W11. Therefore, the burrs V tend to be generated more on the shear side of the outside of the plasticized region W11. On the other hand, for example, in a case where the rotational speed of the joining rotary tool F is fast, though the temperature of the plastically fluidized material rises more on the shear side, the high rotational speed causes the recessed groove to be formed on the flow side of the inside of the plasticized region W11. Therefore, the burrs V tend to be generated more on the flow side of the outside of the plasticized region W11.

In the present embodiment, since the rotational speed of the joining rotary tool F is set to be fast, as shown in FIG. 28, the burrs V is generated more on the flow side of the outside of the plasticized region W11. In the present embodiment, since the auxiliary member 106 is simultaneously joined by friction stir, the recessed groove is not formed in the plasticized region W11, preventing short supply of metal to the plasticized region W11. Further, the rotational speed of the joining rotary tool F is set to be fast, to increase the moving speed (feeding speed) of the joining rotary tool F. This shortens a joining cycle.

In the joining step, it depends on a joining condition on which side of the moving path of the joining rotary tool F the burrs V are generated. The joining condition is determined by each factor such as the rotational speed, rotation direction, moving speed (feeding speed) of the joining rotary tool F, an inclination angle (tapered angle) of the stirring pin F2, materials of the jacket body 102 and the first substrate 121, and the thickness of the first substrate 121, and combinations thereof. According to the joining condition, if the side on which the burrs V are generated or are generated more is set to be closer to the auxiliary member 106, the removing step to be described later is easily executed.

In the joining step, the joining rotational tool F is moved along the entire first butted butted portion J11, and is disengaged in the plasticized region W11. In the joining step, the start point of the plasticized region W11 is overlapped with the end point.

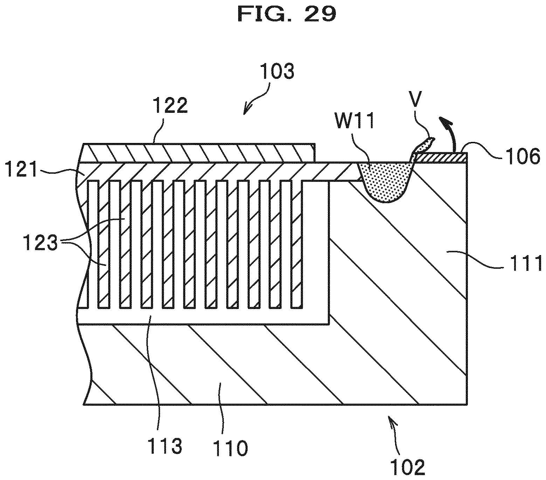

As shown in FIG. 29, in the removing step, the auxiliary member 106 is removed. In the removing step, the end of the auxiliary member 106 is turned up at the slit 107 (see FIG. 27) and folded toward the center of the first substrate 121 to remove the auxiliary member 106. In the removing step, the auxiliary member 106 may be folded by a device, but, in the present embodiment, is folded manually. Accordingly, the liquid-cooled jacket 101 shown in FIG. 20 is manufactured.

According to the method for manufacturing a liquid-cooled jacket and the liquid-cooled jacket 101 as described above, the jacket body 102 is joined by friction stir with the seal body 103, to increase the water-tightness and air-tightness. Further, the seal body 103 is formed to have the periphery of the first substrate 121 exposed and is joined by friction stir at the periphery, to prevent the first metal (aluminum alloy) from being mixed with the second metal (copper alloy) at the time of friction stir joining. That is, since influence of the second metal can be omitted at the time of joining step, the joining condition is easily set for friction stir joining.

Still further, the seal body 103 may be formed by any method, but is easily formed by the first cutting step, the second cutting step and the fin-forming step. Yet further, as described in the present embodiment, only the stirring pin F2 is brought in contact with the peripheral wall 111 and the first substrate 121 for friction stir, to allow the first butted portion J11 to be joined by friction stir at a deep position, without a large load being applied on the friction stir device.

Here, in a case where the shoulder is brought in contact with the peripheral wall 111 and the first substrate 121 as in the prior art, the width of the stepped bottom face 115a must be formed larger to prevent the plastically fluidized material from flowing into the liquid-cooled jacket 101. However, as in the present embodiment, only the stirring pin F2 is brought in contact with the peripheral wall 111 and the first substrate 121 for friction stir, to allow for reducing the width of the plasticized region W11. This reduces the width of the stepped bottom face 115a to increase flexibility in design.

Further, in the present embodiment, since the auxiliary member 106 is also joined by friction stir in addition to the peripheral wall 111 and the first substrate 121, to prevent short supply of metal to the plasticized region W11.

Further, as in the joining step according to the present embodiment, the joining condition is set such that the burrs V are generated on the auxiliary member 106, to allow the burrs V generated in friction stir joining to be easily removed with the auxiliary member 106. Thus, the joined portion (plasticized region W11) is clearly finished without a burr removing work separately.

Further, the materials of the first substrate 121 and the second substrate 122 are not particularly limited, but as in the present embodiment, the first substrate 121 may be made of aluminum alloy (first metal) and the second substrate 122 mounted with the heating element may be made of copper alloy (second metal), to enhance the heat conductivity.

### [Fourth Embodiment]

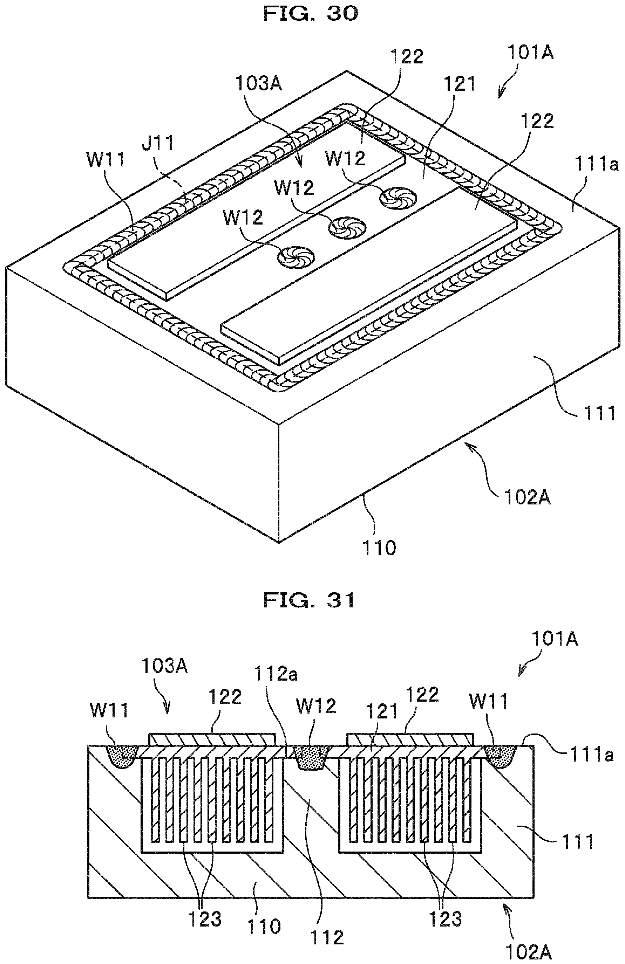

Next, a description will be given of a liquid-cooled jacket and a method for manufacturing the liquid-cooled jacket according to a fourth embodiment of the present invention. As shown in FIGS. 30 and 31, a liquid-cooled jacket 101A according to the fourth embodiment has a jacket body 102A and a seal body 103A. The liquid-cooled jacket 100A is different from the third embodiment on the point that a support 112 is formed, and other points in the fourth embodiment different from the third embodiment will be mainly described.

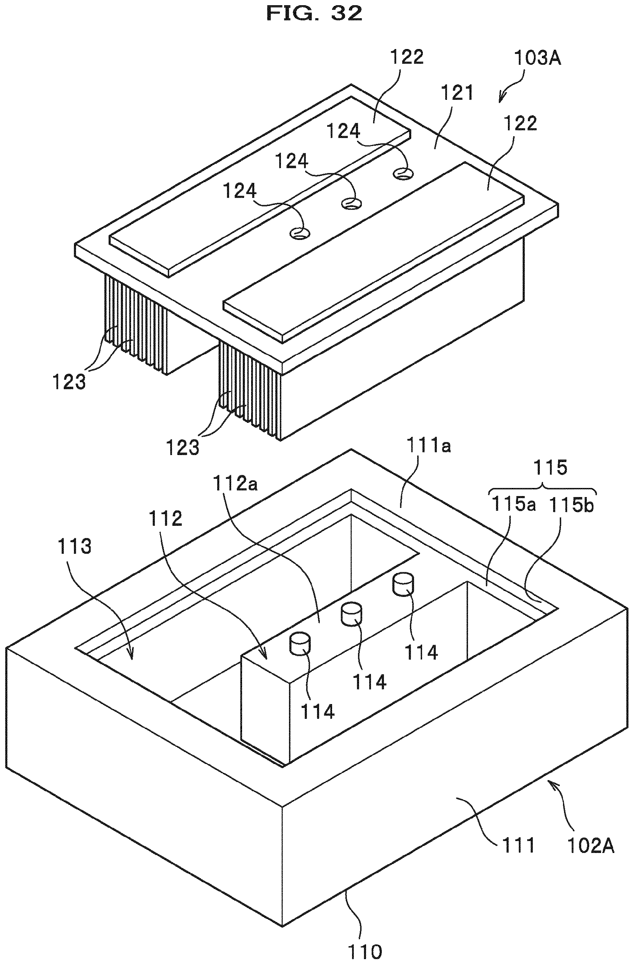

As shown in FIGS. 31 and 32, the jacket body 102A includes a bottom 110, a peripheral wall 111 and the support 112. A stepped portion 115 is formed at the inner peripheral edge of the peripheral wall 111. The support 112 is a plate-shaped member that is formed to vertically extend upward from the bottom 110. The support 112 is formed continuously to one wall of the peripheral wall 111 and is spaced apart from the other wall that faces the one wall. An end face 112a of the support 112 is flush with a stepped bottom face 115a of the stepped portion 115. Protrusions 114 are formed on the end face 112a of the support 112. The protrusions 114 have approximately the same height as the thickness of a first substrate 121. The protrusions 114 may have any shape and are in a cylindrical shape in the present embodiment. The number of protrusions 114 is not particularly limited and three protrusions are formed in the present embodiment.

As shown in FIGS. 31 and 32, the seal body 103A has the first substrate 121, second substrates 122, a plurality of fins 123, and three holes 124. The pair of second substrates 122 is formed on both sides of the holes 124. The fins 123 are formed at positions corresponding to the second substrates 122. That is, the fins 123 are not formed in an area where the holes 124 are formed and the vicinity thereof. The holes 124 penetrate the central portion of the first substrate 121 in the thickness direction. The holes 124 are formed to have a size in which the protrusions 114 are inserted without clearance.

Next, a description will be given of the method for manufacturing the liquid-cooled jacket according to the fourth embodiment. The method for manufacturing a liquid-cooled jacket includes a preparing step, a seal body arranging step, an auxiliary member arranging step, a joining step, and a removing step.

In the preparing step, the jacket body 102A and the seal body 103A are formed. As shown in FIG. 32, the jacket body 102A is formed by, for example, die-casting. Further, the preparing step includes a clad member forming step, a first cutting step, a second cutting step and a fin-forming step, to form the seal body 103A. The clad member forming step is the same as that in the third embodiment to form the clad member 130 in FIG. 21.

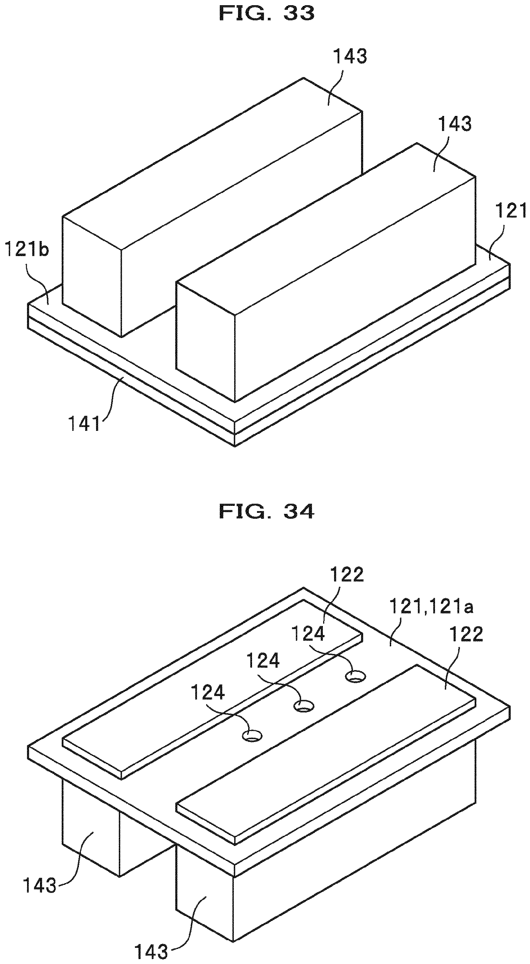

As shown in FIG. 33, in the first cutting step, a portion of the first base 131 (see FIG. 21) is cut off to form the first substrate 121 and blocks 143. In the first cutting step, the first base 131 is cut with a cutting machine or the like. With this step, the plate-shaped first substrate 121 is formed, and the blocks 43 are formed on a rear face 121b of the first substrate 121.

As shown in FIG. 34, in the second cutting step, a portion of a second base 141 (see FIG. 33) is cut off to form the second substrates 122. In the second cutting step, the peripheral edge and the central portion of the second base 141 are cut off with the cutting machine or the like to form the second substrates 122 so as to have the peripheral edge and the central portion of the first substrate 121 exposed. Accordingly, the second substrates 122 apart from each other are formed on a front face 121a of the first substrate 121. Further, in the second cutting step, the three penetrating holes 124 are formed at the central portion of the first substrate 121.

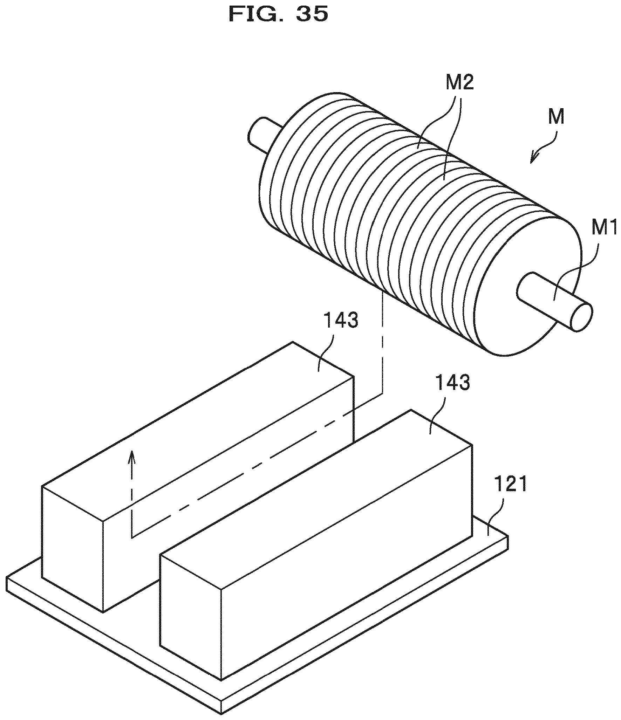

As shown in FIG. 35, in the fin-forming step, the blocks 143 are cut into the fins 23 (see FIG. 31) with a multi-cutter M. The fin-forming step is the same as that in the third embodiment to form the fins 23.

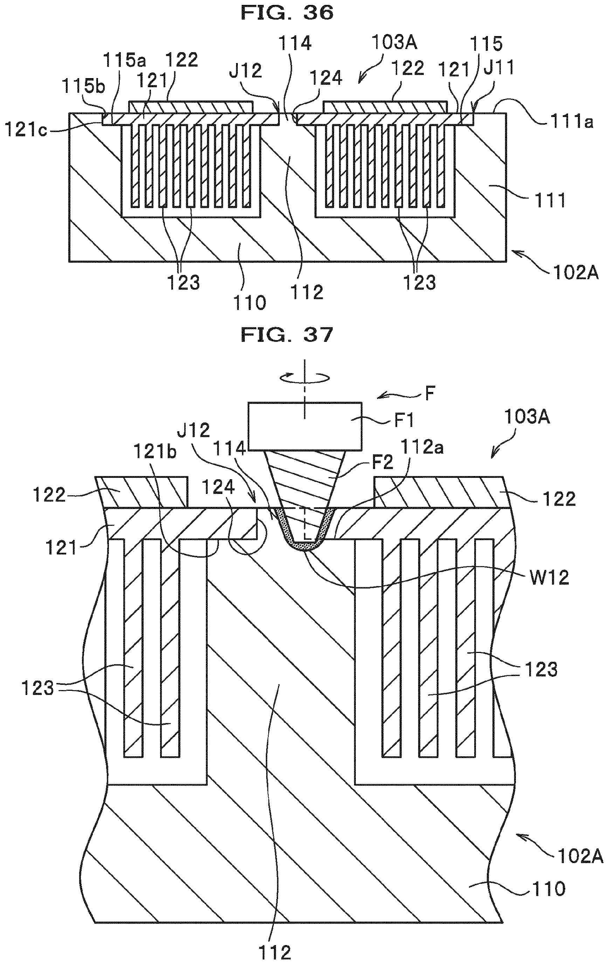

In the seal body arranging step, the seal body 103A is arranged on the jacket body 102A to form a first butted portion J11 and a second butted portion J12. As shown in FIG. 36, in the seal body arranging step, the first substrate 121 is arranged on the stepped bottom face 115a of the stepped portion 115. Accordingly, a stepped side face 115b is butted with a side face 121c of the first substrate 121 to form the first butted portion J11. Further, the protrusions 114 are inserted in the holes 124 to form the butted portion J12 where the outer periphery of each protrusion 114 is butted with the wall of each hole 124.

Further, in the auxiliary member arranging step, though not specifically illustrated, an auxiliary member is arranged along the first butted portion J11 in the same manner as the third embodiment. The jacket body 102A, the seal body 103A and the auxiliary member are immovably fixed on a table with a fixing jig such as a clamp.

As shown in FIG. 37, the joining step includes a first joining step and a second joining step with a joining rotary tool F. The first joining step is the same as the joining step in the third embodiment, and the description thereof is omitted. In the second joining step, the butted portion J12 is joined by friction stir. The first joining step may be done prior to the second joining step, but is done vice versa in the present embodiment.

In the second joining step, the rotating joining rotary tool F is moved along the entire butted portion J12 for joining. The joining rotary tool F may be inserted such that the stirring pin F2 does not reach the end face 112a of the support 112, but, in the present embodiment, the stirring pin F2 is made to contact the end face 112a of the support 112 to further join by friction stir the overlaid portion between the end face 112a and the rear face 121b of the first substrate 121. A plasticized region W12 is formed in the second joining step.

The removing step is the same as that in the third embodiment, and the description thereof is omitted. With this step, the liquid-cooled jacket 101A shown in FIGS. 30 and 31 is formed.

The method for manufacturing a liquid-cooled jacket, and the liquid-cooled jacket 101A described above also provide the same advantageous effects as the third embodiment. Further, since the protrusions 114 formed on the support 112 are inserted in the holes 124 formed in the seal body 103A, the seal body 103A is easily positioned. Further, the support 112 is joined to the seal body 103A to increase the strength of the liquid-cooled jacket 100A.

Here, in a case where a shoulder is brought in contact with the protrusions 114 and the first substrate 121 as in the prior art, the width of the support 112 must be formed larger so as to prevent the plastically fluidized material from flowing into the liquid-cooled jacket 101A. However, as in the present embodiment, only the stirring pin F2 is brought in contact with the protrusions 114 and the first substrate 121 for friction stir, to allow for reducing the width of the plasticized region W12. This reduces the width of the support 112 to increase flexibility in design.

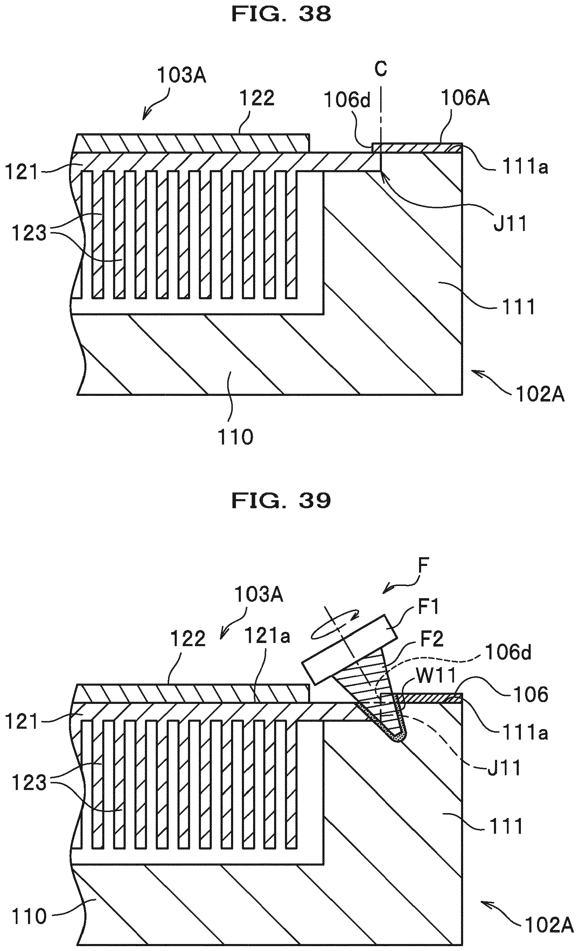

FIG. 38 is a cross-sectional view of a first modification. As illustrated in FIG. 38, in the auxiliary member arranging step, the auxiliary member 106A may be arranged to extend inward so as to have its inner peripheral face 106d located beyond the first butted portion J11. Short supply of metal to the plasticized region W11 is prevented more reliably by arranging the auxiliary member 106A as such. Further, the joining rotary tool F is easily inserted from the front face of the auxiliary member 106A. The location of the auxiliary member 106A (inner peripheral face 106d) is preferably controlled so that no short supply of metal occurs in any part of the plasticized region W11, and the the auxiliary member 106A does not remain on the peripheral wall 111 after the removing step.

FIG. 39 is a cross-sectional view of a second modification. As shown in FIG. 39, in the joining step, friction stir joining may be applied in a state that the center axis for rotation of the joining rotary tool F inclined inward (toward the center of the jacket body 102A). In other words, in the joining step, the stirring pin F2 may be inserted at an angle from an inner corner defined by the front face 121a of the first substrate 121 and the inner peripheral face 106d of the auxiliary member 106. Even in this manner, the peripheral wall 111, the first substrate 121 and the auxiliary member 106 are easily joined, and the short supply of metal to the joined portion (plasticized region W11) is securely prevented. Further, the stirring pin F2 is easily inserted from the inner corner. Still further, in the second modification, the joining rotary tool F may be attached to a robot arm having a driving means such as a spindle unit at the tip to execute the joining step. Thus, the center axis for rotation of the joining rotary tool F is easily inclined.

For example, in the joining step, the rotary tool having a shoulder and a stirring pin may be used for friction stir joining, with the shoulder pressing the first substrate 121. Further, the rotary tool may be used for friction stir joining, with only the stirring pin F2 being in contact with joined metal members. Still further, though the seal body 103A has the fins 123 in the present embodiment, a liquid-cooled jacket may be manufactured without the fins 123. Yet further, in the present embodiment, the auxiliary member 106 is used in the joining step, but may not be used therein.

### EXPLANATION OF REFERENCES

1: liquid-cooled jacket 2: jacket body 3: seal body 10: bottom 11: peripheral wall 11a: end face 12: support 12a: end face 13: recess 14: protrusion 23: fin 24: hole 101: liquid-cooled jacket 102: jacket body 103: seal body 110: bottom 111: peripheral wall 111a: end face 112: support 112a: end face 113: recess 114: protrusion 124: hole F: joining rotary tool (rotary tool) F2: stirring pin J1: overlaid portion J2: butted portion J11: first butted portion J12: second butted portion W: plasticized region W11: plasticized region

## Claims

1. A method for manufacturing a liquid-cooled jacket (1, 1A, 101, 101A), comprising steps of:
preparing to form a jacket body (2, 2A, 102, 102A) that has a bottom (10, 110) and a peripheral wall (11, 111) extending upward from a peripheral edge of the bottom (10, 110), as well as a seal body (3, 3A, 103, 103A) that has a first substrate (21, 121) formed of a first metal in a plate shape, a second substrate (22, 122) formed of a second metal in a plate shape on a front face (21a, 121a) of the first substrate (21, 121) so as to have a peripheral edge of the first substrate (21, 121) be exposed, and a plurality of fins (23, 123) arranged in parallel on a rear face (21b, 121b) of the first substrate (21, 121);
arranging the seal body (3, 3A, 103, 103A) on the jacket body (2, 2A, 102, 102A) to form an overlaid portion (J1) with an end face (11a, 111a) of the peripheral wall (11, 111) and a rear face (21b, 121b) of the first substrate (21, 121) overlaid thereon; and
joining by friction stir the overlaid portion (J1) by inserting a rotary tool (F) from a front face (21a, 121a) of the peripheral edge of the first substrate (21, 121) and by moving the rotary tool (F) along the overlaid portion (J1) relatively in a state where a stirring pin (F2) of the rotary tool (F) is contacted with only the first substrate (21, 121) or with both the first substrate (21, 121) and the peripheral wall (11, 111),
wherein in the preparing step, a support (12, 112) having a protrusion (14, 114) on an end face (12a, 112a) thereof is formed on the bottom (10, 110) of the jacket body (2, 2A, 102, 102A),
wherein the first substrate (21, 121) is formed to have a hole (24, 124) therein and the second substrate (22, 122) is formed to have a vicinity of the hole (24, 124) be exposed on the front face (21a, 121a) of the first substrate (21, 121),
wherein in the arranging step, the overlaid portion (J1) is formed and the protrusion (14, 114) is inserted in the hole (24, 124), and
wherein in the joining step, friction stir joining is applied to a butted portion (J2, J12) that is formed with an outer periphery of the protrusion (14, 114) butted with a wall of the hole (24, 124).

2. The method for manufacturing a liquid-cooled jacket (1, 1A, 101, 101A) according to claim 1, wherein the preparing step comprising steps of:
forming a clad (30, 130) that has a first base (31, 131) formed of the first metal cladded on a second base (41, 141) formed of the second metal;
first cutting to cut the first base (31, 131) so as to form the first substrate (21, 121) and a block (43, 143);
second cutting to cut the second base (41, 141) so as to have the peripheral edge of the first substrate (21, 121) be exposed and form the second substrate (22, 122); and
fin forming to cut the block (43, 143) with a multi-cutter having disc cutters (M2) arranged in parallel so as to form the plurality of fins (23, 123).

3. The method for manufacturing a liquid-cooled jacket (1, 1A, 101, 101A) according to claim 1 or 2,
wherein, in the joining step, friction stir joining is applied to the overlaid portion (J1) in a state where only the stirring pin (F2) of the rotary tool (F) is contacted with only the first substrate (21, 121) or with both the first substrate (21, 121) and the peripheral wall (11, 111).

4. The method for manufacturing a liquid-cooled jacket (1, 1A, 101, 101A) according to any one of the preceding claims,
wherein, in the joining step, a joining condition is set to generate a burr (V) outside the first substrate (21, 121), and
the method further comprises:
removing a redundant portion (25) of the first substrate (21, 121) along a recessed groove (D) formed in a plasticized region (W) as a boundary.

5. The method for manufacturing a liquid-cooled jacket (1, 1A, 101, 101A) according to any one of the preceding claims, wherein the first metal is made of aluminum alloy and the second metal is made of copper alloy.

6. A liquid-cooled jacket (1, 1A, 101, 101A) comprising:
a jacket body (2, 2A, 102, 102A) that has a bottom (10, 110) and a peripheral wall (11, 111) extending upward from a peripheral edge of the bottom (10, 110); and
a seal body (3, 3A, 103, 103A) that has a first substrate (21, 121) in a plate shape formed of a first metal, a second substrate (22, 122) in a plate shape formed of a second metal on a front face (21a, 121a) of the first substrate (21, 121) so as to have a peripheral edge of the first substrate (21, 121) be exposed, and a plurality of fins (23, 123) arranged in parallel on a rear face (21b, 121b) of the first substrate (21, 121),
wherein friction stir joining is applied to an overlaid portion (J1) formed with an end face (11a, 111a) of the peripheral wall (11, 111) and a rear face (21b, 121b) of the seal body (3, 3A, 103, 103A) overlaid thereon, to form a plasticized region (W, W11, W12) along the peripheral edge of the first substrate (21, 121),
wherein a support (12, 112) having a protrusion (14, 114) on an end face (12a, 112a) thereof is formed on the bottom (10, 110) of the jacket body (2, 2A, 102, 102A),
wherein the first substrate (21, 121) is formed to have a hole (24, 124) therein and the second substrate (22, 122) is formed to have a vicinity of the hole (24, 124) be exposed, and
wherein friction stir joining is applied to a butted portion (J2, J12) that is formed with an outer periphery of the protrusion (14, 114) butted with a wall of the hole (24, 124).

7. A method for manufacturing a liquid-cooled jacket (1, 1A, 101, 101A), comprising steps of:
preparing to form a jacket body (2, 2A, 102, 102A) that has a bottom (10, 110), a peripheral wall (11, 111) that extends upward from a peripheral edge of the bottom (10, 110), a stepped bottom face (115a) that is formed lower than an end face (111a) of the peripheral wall (11, 111) by one step, and a stepped side face (115b) that extends upward from the stepped bottom face (115a), as well as a seal body (3, 3A, 103, 103A) that has a first substrate (21, 121) formed of a first metal in a plate shape, a second substrate (22, 122) formed of a second metal in a plate shape on a front face (21a, 121a) of the first substrate (21, 121) so as to have a peripheral edge of the first substrate (21, 121) be exposed, and a plurality of fins (23, 123) arranged in parallel on a rear face (21b, 121b) of the first substrate (21, 121);
seal body arranging to arrange the seal body (3, 3A, 103, 103A) on the jacket body (2, 2A, 102, 102A), so as to butt the stepped side face (115b) with a side face (121c) of the first substrate (21, 121) to form a first butted portion (J11); and
joining by friction stir the first butted portion (J11) by inserting a rotary tool (F) and by moving the rotary tool (F) along the first butted portion (J11) relatively in a state where a stirring pin (F2) of the rotary tool (F) is contacted with both the first substrate (21, 121) and the peripheral wall (11, 111),
wherein in the preparing step, a support (12, 112) having a protrusion (14, 114) on an end face (12a, 112a) thereof is formed on the bottom (10, 110) of the jacket body (2, 2A, 102, 102A),
wherein the first substrate (21, 121) is formed to have a hole (24, 124) therein and the second substrate (22, 122) is formed to have a vicinity of the hole (24, 124) be exposed on a front face (21a, 121a) of the first substrate (21, 121),
wherein in the seal body arranging step, the first butted portion (J11) is formed and the protrusion (14, 114) is inserted in the hole (24, 124), and
wherein in the joining step, friction stir joining is applied to a second butted portion (J12) formed with an outer periphery of the protrusion (14, 114) butted with a wall of the hole (24, 124).

8. The method for manufacturing a liquid-cooled jacket (1, 1A, 101, 101 A) according to claim 7, wherein the preparing step comprising steps of:
forming a clad (30, 130) that has a first base (31, 131) formed of the first metal cladded on a second base (41, 141) formed of the second metal;
first cutting to cut the first base (31, 131) so as to form the first substrate (21, 121) and a block (43, 143);
second cutting to cut the second base (41, 141) so as to have the peripheral edge of the first substrate (21, 121) be exposed and form the second substrate (22, 122); and
fin forming to cut the block (43, 143) with a multi-cutter having disc cutters (M2) in parallel so as to form the plurality of fins (23, 123).

9. The method for manufacturing a liquid-cooled jacket (1, 1A, 101, 101A) according to claim 7 or 8,
wherein, in the joining step, friction stir joining is applied in a state where only the stirring pin (F2) of the rotary tool (F) is contacted with the peripheral wall (11, 111) and the first substrate (21, 121).

10. The method for manufacturing a liquid-cooled jacket (1, 1A, 101, 101A) according to claim 9 further comprising:
auxiliary member arranging to arrange an auxiliary member (106, 106A) along the first butted portion (J11),
wherein, in the joining step, friction stir joining is applied to the first butted portion (J11) in a state where only the stirring pin (F2) is contacted with the peripheral wall (11, 111), the first substrate (21, 121) and the auxiliary member (106, 106A),
wherein preferably, in the joining step, a joining condition is set to generate a burr (V) on the auxiliary member (106, 106A), and the method further comprises: removing the auxiliary member (106, 106A) generated with the burr (V), and/or
wherein preferably, in the joining step, friction stir joining is applied in a state where a center axis for rotation of the rotary tool (F) is inclined toward an inside of the jacket body (2, 2A, 102, 102A).

11. The method for manufacturing a liquid-cooled jacket (1, 1A, 101, 101A) according to any one of claims 7 to 10, wherein the first metal is made of aluminum alloy and the second metal is made of copper alloy.

12. A liquid-cooled jacket (1, 1A, 101, 101A) comprising:
a jacket body (2, 2A, 102, 102A) that has a bottom (10, 110), a peripheral wall (11, 111) extending upward from a peripheral edge of the bottom (10, 110), and a stepped portion (115) formed at an inner peripheral edge of the peripheral wall (11, 111); and
a seal body (3, 3A, 103, 103A) that has a first substrate (21, 121) formed of a first metal in a plate shape, a second substrate (22, 122) formed of a second metal in a plate shape so as to have a peripheral edge of the first substrate (21, 121) be exposed on a front face (21a, 121a) of the first substrate (21, 121), and a plurality of fins (23, 123) arranged in parallel on a rear face (21b, 121b) of the first substrate (21, 121),
wherein friction stir joining is applied to a first butted portion (J11) that is formed with a stepped side face (115b) of the stepped portion (115) butted with a side face (121c) of the first substrate (21, 121), and a plasticized region (W, W11, W12) is formed in the peripheral edge of the first substrate (21, 121),
wherein a support (12, 112) having a protrusion (14, 114) on an end face (12a, 112a) thereof is formed on the bottom (10, 110) of the jacket body (2, 2A, 102, 102A),
wherein the first substrate (21, 121) is formed to have a hole (24, 124) therein and the second substrate (22, 122) is formed to have a vicinity of the hole (24, 124) be exposed, and
wherein friction stir joining is applied to a second butted portion (J12) that is formed with an outer periphery of the protrusion (14, 114) butted with a wall of the hole (24, 124).

## Patentansprüche

1. Verfahren zum Herstellen eines flüssigkeitsgekühlten Mantels (1, 1A, 101, 101A), das die Schritte aufweist:
Vorbereiten zum Ausbilden eines Mantelkörpers (2, 2A, 102, 102A), der einen Boden (10, 110) und eine Umfangswand (11, 111) hat, die von einer Umfangskante des Bodens (10, 110) nach oben verläuft, wie auch einen Abdichtungskörper (3, 3A, 103, 103A), der ein erstes Substrat (21, 121), das aus einem ersten Metall in einer Plattenform ausgebildet ist, ein zweites Substrat (22, 122), das aus einem zweiten Metall in einer Plattenform an einer Vorderfläche (21a, 121a) des ersten Substrats (21, 121) ausgebildet ist, sodass eine Umfangskante des ersten Substrats (21, 121) freigelegt ist, und eine Vielzahl von Rippen (23, 123), die parallel an einer hinteren Fläche (21b, 121b) des ersten Substrats (21, 121) angeordnet sind;
Anordnen des Abdichtungskörpers (3, 3A, 103, 103A) am Mantelkörper (2, 2A, 102, 102A), um einen Aufsatzbereich (J1) bei einer Endfläche (11a, 111a) der Umfangswand (11, 111) und einer hinteren Fläche (21b, 121b) des ersten Substrats (21, 121) zu bilden, die darauf aufgesetzt ist; und
Reibrührverbinden des Aufsatzbereichs (J1) durch Einsetzen eines Rotationswerkzeugs (F) von einer Vorderfläche (21a, 121a) der Umfangskante des ersten Substrats (21, 121) und durch Bewegen des Rotationswerkzeugs (F) entlang des Aufsatzbereichs (J1) diesbezüglich in einem Zustand, in dem ein Rührstift (F2) des Rotationswerkzeugs (F) mit nur dem ersten Substrat (21, 121) oder mit beiden von dem ersten Substrat (21, 121) und der Umfangswand (11, 111) in Kontakt steht,
wobei im Vorbereitungsschritt eine Halterung (12, 112), die einen Vorsprung (14, 114) an einer Endfläche (12a, 112a) davon hat, an einem Boden (10, 110) des Mantelkörpers (2, 2A, 102, 102A) ausgebildet ist,
wobei das erste Substrat (21, 121) ausgebildet ist, sodass eine Öffnung (24, 124) darin vorliegt, und das zweite Substrat (22, 121) ausgebildet ist, sodass eine Umgebung der Öffnung (24, 124) an der Vorderfläche (21a, 121a) des ersten Substrats (21, 121) freigelegt ist,
wobei im Anordnungsschritt der Aufsatzbereich (J1) ausgebildet wird und der Vorsprung (14, 114) in die Öffnung (24, 124) eingesetzt wird, und
wobei im Verbindungsschritt die Reibrührverbindung auf einen Aufsatzbereich (J2, J12) angewendet wird, der mit einem Außenumfang des Vorsprungs (14, 114) mit einer Wand der Öffnung (24, 124) aneinandergefügt ausgebildet ist.

2. Verfahren zum Herstellen eines flüssigkeitsgekühlten Mantels (1, 1A, 101, 101A) nach Anspruch 1, wobei der Vorbereitungsschritt die Schritte aufweist:
Ausbilden einer Verkleidung (30, 130), die eine erste Basis (31, 131) hat, die aus dem ersten Metall ausgebildet ist, die auf einer zweiten Basis (41, 141), die aus dem zweiten Metall gebildet ist, verkleidet wird;
erstes Schneiden, um die erste Basis (31, 131) zu schneiden, um so das erste Substrat (21, 121) und einen Block (43, 143) auszubilden;
zweites Schneiden, um die zweite Basis (41, 141) zu schneiden, sodass die Umfangskante des ersten Substrats (21, 121) freigelegt ist, und das zweite Substrat (22, 122) ausbildet; und
Ausbilden von Rippen, um den Block (43, 143) mit einem Mehrfachschneider zu schneiden, der Messerscheiben (M2) hat, die parallel angeordnet sind, um so die Vielzahl der Rippen (23, 123) auszubilden.

3. Verfahren zum Herstellen eines flüssigkeitsgekühlten Mantels (1, 1A, 101, 101A) nach Anspruch 1 oder 2,
wobei im Verbindungsschritt die Reibrührverbindung auf den Aufsatzbereich (J1) in einem Zustand angewendet wird, in dem nur der Rührstift (F2) des Rotationswerkzeugs (F) mit nur dem ersten Substrat (21, 121) oder mit beiden von dem ersten Substrat (21, 121) und der Umfangswand (11, 111) in Kontakt steht.

4. Verfahren zum Herstellen eines flüssigkeitsgekühlten Mantels (1, 1A, 101, 101A) nach einem der vorhergehenden Ansprüche,
wobei im Verbindungschritt eine Verbindungsbedingung festgelegt wird, um einen Grad (V) außerhalb des ersten Substrats (21, 121) zu erzeugen, und
das Verfahren weiterhin aufweist:
Entfernen eines redundanten Bereichs (25) des ersten Substrats (21, 121) entlang einer ausgesparten Nut (D), die in einem plastifizierten Gebiet (W) als eine Grenze ausgebildet ist.

5. Verfahren zum Herstellen eines flüssigkeitsgekühlten Mantels (1, 1A, 101, 101A) nach einem der vorhergehenden Ansprüche, wobei das erste Metall aus einer Aluminiumlegierung hergestellt ist und das zweite Metall aus einer Kupferlegierung hergestellt ist.

6. Flüssigkeitsgekühlter Mantel (1, 1A, 101, 101A), der aufweist:
einen Mantelkörper (2, 2A, 102, 102A), der einen Boden (10, 110) und eine Umfangswand (11, 111) hat, die von einer Umfangskante des Bodens (10, 110) nach oben verläuft, und
einen Abdichtungskörper (3, 3A, 103, 103A), der ein erstes Substrat (21, 121) in einer Plattenform hat, das aus einem ersten Metall ausgebildet ist, ein zweites Substrat (22, 122) in einer Plattenform, das aus einem zweiten Metall an einer Vorderfläche (21a, 121a) des ersten Substrats (21, 121) ausgebildet ist, sodass eine Umfangskante des ersten Substrats (21, 121) freigelegt ist, und eine Vielzahl von Rippen (23, 123) parallel an einer hinteren Fläche (21b, 121b) des ersten Substrats (21, 121) angeordnet sind,
wobei die erste Reibrührverbindung auf einen Aufsatzbereich (J1) angewendet wird, der bei einer Endfläche (11a, 111a) der Umfangswand (11, 111) und einer darauf aufgesetzten hinteren Fläche (21b, 121b) des Abdichtungskörpers (3, 3A, 103, 103A) ausgebildet ist, um ein plastifiziertes Gebiet (W, W11, W12) entlang der Umfangskante des ersten Substrats (21, 121) zu bilden,
wobei eine Halterung (12, 112), die einen Vorsprung (14, 114) an einer Endfläche (12a, 112a) davon hat, an einem Boden (10, 110) des Mantelkörpers (2, 2A, 102, 102A) ausgebildet ist,
wobei das erste Substrat (21, 121) ausgebildet ist, um eine Öffnung (24, 124) darin ausgebildet zu haben, und das zweite Substrat (22, 122) ausgebildet ist, sodass eine Umgebung der Öffnung (24, 124) freigelegt ist, und
wobei die Reibrührverbindung auf einen aneinandergefügten Bereich (J2, J12) angewendet wird, der an einem Außenumfang des Vorsprungs (14, 114) mit einer Wand der Öffnung (24, 124) aneinandergefügt ausgebildet ist.

7. Verfahren zum Herstellen eines flüssigkeitsgekühlten Mantels (1, 1A, 101, 101A), das die Schritte aufweist:
Vorbereiten zum Ausbilden eines Mantelkörpers (2, 2A, 102, 102A), der einen Boden (10, 110), eine Umfangswand (11, 111), die von einer Umfangskante des Bodens (10, 110) nach oben verläuft, eine abgestufte Bodenfläche (115a), die unter einer Endfläche (111a) der Umfangswand (11, 111) durch eine Stufe ausgebildet ist, und eine abgestufte Seitenfläche (115b) hat, die von der abgestuften Bodenfläche (115a) nach oben verläuft, wie auch einen Abdichtungskörper (3, 3A, 103, 103A), der ein erstes Substrat (21, 121) in einer Plattenform hat, das aus einem ersten Metall ausgebildet ist, ein zweites Substrat (22, 122) in einer Plattenform, das aus einem zweiten Metall an einer Vorderfläche (21a, 121a) des ersten Substrats (21, 121) ausgebildet ist, sodass eine Umfangskante des ersten Substrats (21, 121) freigelegt ist, und eine Vielzahl von Rippen (23, 123) parallel an einer hinteren Fläche (21b, 121b) des ersten Substrats (21, 121) angeordnet sind;
Anordnen eines Abdichtungskörpers, um den Abdichtungskörper (3, 3A, 103, 103A) am Mantelkörper (2, 2A, 102, 102A) anzuordnen, um so die gestufte Seitenfläche (115b) mit einer Seitenfläche (121 c) des ersten Substrats (21, 121) aneinanderzufügen, um einen ersten aneinandergefügten Bereich (J11) zu bilden; und
Reibrührverbinden des ersten aneinandergefügten Bereichs (J11) durch Einsetzen eines Rotationswerkzeugs (F) und Bewegen des Rotationswerkzeugs (F) entlang des ersten aneinandergefügten Bereichs (J11) diesbezüglich in einem Zustand, in dem ein Rührstift (F2) des Rotationswerkzeugs (F) mit dem ersten Substrat (21, 121) und der Umfangswand (11, 111) in Kontakt steht,
wobei im Vorbereitungsschritt eine Halterung (12, 112), die einen Vorsprung (14, 114) an einer Endfläche (12a, 112a) davon hat, an einem Boden (10, 110) des Mantelkörpers (2, 2A, 102, 102A) ausgebildet ist,
wobei das erste Substrat (21, 121) ausgebildet ist, um eine Öffnung (24, 124) darin ausgebildet zu haben, und das zweite Substrat (22, 121) ausgebildet ist, sodass eine Umgebung der Öffnung (24, 124) an einer Vorderfläche (21a, 121a) des ersten Substrats (21, 121) freigelegt ist,
wobei im Anordnungsschritt des Abdichtungskörpers der erste aneinandergefügte Bereich (J11) ausgebildet wird und der Vorsprung (14, 114) in die Öffnung (24, 124) eingesetzt wird, und
wobei im Verbindungsschritt die Reibrührverbindung auf einen zweiten aneinandergefügten Bereich (J12) angewendet wird, der an einem Außenumfang des Vorsprungs (14, 114) mit einer Wand der Öffnung (24, 124) aneinandergefügt ausgebildet ist.

8. Verfahren zum Herstellen eines flüssigkeitsgekühlten Mantels (1, 1A, 101, 101A) nach Anspruch 7,
wobei der Vorbereitungsschritt die Schritte aufweist:
Ausbilden einer Verkleidung (30, 130), die eine erste Basis (31, 131) hat, die aus dem ersten Metall ausgebildet ist, die auf einer zweiten Basis (41, 141), die aus dem zweiten Metall gebildet ist, verkleidet ist;
erstes Schneiden, um die erste Basis (31, 131) zu schneiden, um so das erste Substrat (21, 121) und einen Block (43, 143) auszubilden;
zweites Schneiden, um die zweite Basis (41, 141) zu schneiden, sodass die Umfangskante des ersten Substrats (21, 121) freigelegt ist, und das zweite Substrat (22, 122) bilden; und
Bilden von Rippen, um den Block (43, 143) mit einem Mehrfachschneider, der Messerscheiben (M2) parallel hat, zu schneiden, um so die Vielzahl der Rippen (23, 123) auszubilden.

9. Verfahren zum Herstellen eines flüssigkeitsgekühlten Mantels (1, 1A, 101, 101A) nach Anspruch 7 oder 8, wobei im Verbindungsschritt die Reibrührverbindung in einem Zustand angewendet wird, in dem nur der Rührstift (F2) des Rotationswerkzeugs (F) mit der Umfangswand (11, 111) und dem ersten Substrat (21, 121) in Kontakt steht.

10. Verfahren zum Herstellen eines flüssigkeitsgekühlten Mantels (1, 1A, 101, 101A) nach Anspruch 9, das weiterhin aufweist:
Anordnen eines Hilfselements, um ein Hilfselement (106, 106A) entlang dem ersten aneinandergefügten Bereich (J11) anzuordnen,
wobei im Verbindungsschritt die Reibrührverbindung auf den ersten aneinandergefügten Bereich (J11) in einem Zustand angewendet wird, in dem nur der Rührstift (F2) mit der Umfangswand (21, 121), dem ersten Substrat (21, 121) und dem Hilfselement (106, 106A) in Kontakt steht,
wobei vorzugsweise im Verbindungsschritt eine Verbindungsbedingung festgelegt wird, um einen Grad (V) auf dem Hilfselement (106, 106A) zu erzeugen, und das Verfahren weiterhin aufweist:
Entfernen des Hilfselements (106, 106A), das mit dem Grad (V) erzeugt wurde, und/oder
wobei vorzugsweise im Verbindungsschritt die Reibrührverbindung in einem Zustand angewendet wird, in dem eine Mittelachse zur Rotation des Rotationswerkzeugs (F) in Richtung einer Innenseite des Mantelkörpers (2, 2A, 102, 102A) geneigt ist.

11. Verfahren zum Herstellen eines flüssigkeitsgekühlten Mantels (1, 1A, 101, 101A) nach einem der Ansprüche 7 bis 10, wobei das erste Metall aus einer Aluminiumlegierung hergestellt ist und das zweite Metall aus einer Kupferlegierung hergestellt ist.

12. Flüssigkeitsgekühlter Mantel (1, 1A, 101, 101A) , der aufweist:
einen Mantelkörper (2, 2A, 102, 102A), der einen Boden (10, 110), eine Umfangswand (11, 111), die von einer Umfangskante des Bodens (10, 110) nach oben verläuft, und einen abgestuften Bereich (115) hat, der an einer Innenumfangskante der Umfangswand (11,111) ausgebildet ist; und
einen Abdichtungskörper (3, 3A, 103, 103A), der ein erstes Substrat (21, 121) hat, das aus einem ersten Metall in einer Plattenform ausgebildet ist, ein zweites Substrat (22, 122), das aus einem zweiten Metall in einer Plattenform ausgebildet ist, sodass eine Umfangskante des ersten Substrats (21, 121) an einer Vorderfläche (21a, 121a) ersten Substrats (21, 121) freigelegt ist, und eine Vielzahl von Rippen (23, 123) die parallel an eine hinteren Fläche (21b, 121b) des ersten Substrats (21, 121) angeordnet sind,
wobei eine Reibrührverbindung auf den ersten aneinandergefügten Bereich (J11) angewendet wird, der mit einer gestuften Seitenfläche (115b) des gestuften Bereichs (115) ausgebildet ist, der mit einer Seitenfläche (121c) des ersten Substrats (21, 121) aneinandergefügt ist, und ein plastifiziertes Gebiet (W, W11, W12) in der Umfangskante des ersten Substrats (21, 121) ausgebildet ist,
wobei eine Halterung (12, 112), die einen Vorsprung (14, 114) an einer Endfläche (12a, 112a) davon hat, an einem Boden (10, 110) des Mantelkörpers (2, 2A, 102, 102A) ausgebildet ist,
wobei das erste Substrat (21, 121) ausgebildet ist, sodass eine Öffnung (24, 124) darin ausgebildet ist, und das zweite Substrat (22, 122) ausgebildet ist, sodass eine Umgebung der Öffnung (24, 124) freigelegt ist, und
wobei die Reibrührverbindung auf einen zweiten aneinandergefügten Bereich (J12) angewendet wird, der an einem Außenumfang des Vorsprungs (14, 114) mit einer Wand der Öffnung (24, 124) aneinandergefügt ausgebildet ist.

## Revendications

1. Procédé pour fabriquer une chemise refroidie par liquide (1, 1A, 101, 101A) comprenant les étapes consistant à :
préparer la formation d'un corps de chemise (2, 2A, 102, 102A) qui a un fond (10, 110) et une paroi périphérique (11, 111) s'étendant vers le haut à partir d'un bord périphérique du fond (10, 110), ainsi qu'un corps de joint d'étanchéité (3, 3A, 103, 103A) qui a un premier substrat (21, 121) formé avec un premier métal en forme de plaque, un second substrat (22, 122) formé avec un second métal en forme de plaque sur une face avant (21a, 121a) du premier substrat (21, 121) afin d'avoir un bord périphérique du premier substrat (21, 121) exposé, et une pluralité d'ailettes (23, 123) agencées parallèlement à une face arrière (21b, 121b) du premier substrat (21, 121) ;
agencer le corps de joint d'étanchéité (3, 3A, 103, 103A) sur le corps de chemise (2, 2A, 102, 102A) pour former une partie recouverte (J1) avec une face d'extrémité (11a, 111a) de la paroi périphérique (11, 111) et une face arrière (21b, 121b) du premier substrat (21, 121) superposé sur ce dernier ; et
assembler, par friction - malaxage, la partie recouverte (J1) en insérant un outil rotatif (F) à partir d'une face avant (21a, 121a) du bord périphérique du premier substrat (21, 121) et en déplaçant l'outil rotatif (F) le long de la partie recouverte (J1) relativement dans un état dans lequel une broche de malaxage (F2) de l'outil rotatif (F) est uniquement en contact avec le premier substrat (21, 121) ou à la fois avec le premier substrat (21, 121) et la paroi périphérique (11, 111),
dans lequel, à l'étape de préparation, un support (12, 112) ayant une saillie (14, 114) sur sa face d'extrémité (12a, 112a), est formé sur le fond (10, 110) du corps de chemise (2, 2A, 102, 102A),
dans lequel le premier substrat (21, 121) est formé pour avoir un trou (24, 124) à l'intérieur de ce dernier et le second substrat (22, 122) est formé pour avoir une proximité du trou (24, 124) exposé sur la face avant (21a, 121a) du premier substrat (21, 121),
dans lequel, à l'étape d'agencement, la partie recouverte (J1) est formée et la saillie (14, 114) est insérée dans le trou (24, 124), et
dans lequel à l'étape d'assemblage, l'assemblage par friction - malaxage est appliqué sur une partie aboutée (J2, J12) qui est formée avec une périphérie externe de la saillie (14, 114) aboutée avec une paroi du trou (24, 124).

2. Procédé pour fabriquer une chemise refroidie par liquide (1, 1A, 101, 101A) selon la revendication 1, dans lequel l'étape de préparation comprenant les étapes consistant à :
former une gaine (30, 130) qui a une première base (31, 131) formée avec un premier métal gainé sur une seconde base (41, 141) formée avec le second métal ;
couper, dans un premier temps, la première base (31, 131) afin de former le premier substrat (21, 121) et un bloc (43, 143) ;
couper, dans un second temps, la seconde base (41, 141) afin d'avoir le bord périphérique du premier substrat (21, 121) exposé et former le second substrat (22, 122) ; et
former une ailette pour couper le bloc (43, 143) avec plusieurs dispositifs de coupe ayant des dispositifs de coupe à disque (M2) agencés en parallèle afin de former la pluralité d'ailettes (23, 123).

3. Procédé pour fabriquer une chemise refroidie par liquide (1, 1A, 101, 101A) selon la revendication 1 ou 2,
dans lequel, à l'étape d'assemblage, l'assemblage par friction - malaxage est appliqué sur la partie recouverte (J1) dans un état dans lequel seule la broche de malaxage (F2) de l'outil rotatif (F) est en contact uniquement avec le premier substrat (21, 121) ou à la fois avec le premier substrat (21, 121) et la paroi périphérique (11, 111).

4. Procédé pour fabriquer une chemise refroidie par liquide (1, 1A, 101, 101A) selon l'une quelconque des revendications précédentes,
dans lequel, à l'étape d'assemblage, une condition d'assemblage est déterminée pour générer une bavure (V) à l'extérieur du premier substrat (21, 121), et
le procédé comprend en outre l'étape consistant à :
retirer une partie redondante (25) du premier substrat (21, 121) le long d'une rainure évidée (D) formée dans une région plastifiée (W) en tant que limite.

5. Procédé pour fabriquer une chemise refroidie par liquide (1, 1A, 101, 101A) selon l'une quelconque des revendications précédentes, dans lequel le premier métal est réalisé avec un alliage d'aluminium et le second métal est réalisé avec un alliage de cuivre.

6. Chemise refroidie par liquide (1, 1A, 101, 101A) comprenant :
un corps de chemise (2, 2A, 102, 102A) qui a un fond (10, 110) et une paroi périphérique (11, 111) s'étendant vers le haut à partir d'un bord périphérique du fond (10, 110) ; et
un corps de joint d'étanchéité (3, 3A, 103, 103A) qui a un premier substrat (21, 121) en forme de plaque formé avec un premier métal, un second substrat (22, 122) en forme de plaque formé avec un second métal sur une face avant (21a, 121a) du premier substrat (21, 121) afin d'avoir un bord périphérique du premier substrat (21, 121) exposé, et une pluralité d'ailettes (23, 123) agencées parallèlement à une face arrière (21b, 121b) du premier substrat (21, 121),
dans laquelle l'assemblage par friction - malaxage est appliqué sur une partie recouverte (J1) formée avec une face d'extrémité (11a, 111a) de la paroi périphérique (11, 111) et une face arrière (21b, 121b) du corps de joint d'étanchéité (3, 3A, 103, 103A) superposée sur cette dernière, afin de former une région plastifiée (W, W11, W12) le long du bord périphérique du premier substrat (21, 121),
dans laquelle un support (12, 112) ayant une saillie (14, 114) sur sa face d'extrémité (12a, 112a), est formé sur le fond (10, 110) du corps de chemise (2, 2A, 102, 102A),
dans laquelle le premier substrat (21, 121) est formé pour avoir un trou (24, 124) à l'intérieur de ce dernier et le second substrat (22, 122) est formé pour avoir une proximité du trou (24, 124) exposé, et
dans laquelle l'assemblage par friction - malaxage est appliqué sur une partie aboutée (J2, J12) qui est formée avec une périphérie externe de la saillie (14, 114) aboutée avec une paroi du trou (24, 124).

7. Procédé pour fabriquer une chemise refroidie par liquide (1, 1A, 101, 101A) comprenant les étapes consistant à :
préparer la formation d'un corps de chemise (2, 2A, 102, 102A) qui a un fond (10, 110), une paroi périphérique (11, 111) qui s'étend vers le haut à partir d'un bord périphérique du fond (10, 110), une face inférieure étagée (115a) qui est formée plus basse qu'une face d'extrémité (111a) de la paroi périphérique (11, 111) d'un étage, et une face latérale étagée (115b) qui s'étend vers le haut à partir de la face inférieure étagée (115a) ainsi qu'un corps de joint d'étanchéité (3, 3A, 103, 103A) qui a un premier substrat (21, 121) formé avec un premier métal en forme de plaque, un second substrat (22, 122) formé avec un second métal en forme de plaque sur une face avant (21a, 121a) du premier substrat (21, 121) afin d'avoir un bord périphérique du premier substrat (21, 121) exposé, et une pluralité d'ailettes (23, 123) agencées en parallèle sur une face arrière (21b, 121b) du premier substrat (21, 121) ;
agencer le corps de joint d'étanchéité pour agencer le corps de joint d'étanchéité (3, 3A, 103, 103A) sur le corps de chemise (2, 2A, 102, 102A), afin de venir en butée contre la face latérale étagée (115b) avec une face latérale (121c) du premier substrat (21, 121) afin de former une première partie aboutée (J11) ; et
assembler par friction - malaxage la première partie aboutée (J11) en insérant un outil rotatif (F) et en déplaçant l'outil rotatif (F) le long d'une première partie aboutée (J11) relativement dans un état dans lequel une broche de malaxage (F2) de l'outil rotatif (F) est en contact à la fois avec le premier substrat (21, 121) et la paroi périphérique (11, 111),
dans lequel à l'étape de préparation, un support (12, 112) ayant une saillie (14, 114) sur sa face d'extrémité (12a, 112a), est formé sur le fond (10, 110) du corps de chemise (2, 2A, 102, 102A),
dans lequel le premier substrat (21, 121) est formé pour avoir un trou (24, 124) à l'intérieur de ce dernier et le second substrat (22, 122) est formé pour avoir une proximité du trou (24, 124) exposé sur une face avant (21a, 121a) du premier substrat (21, 121),
dans lequel, à l'étape d'agencement de corps de joint d'étanchéité, la première partie aboutée (J11) est formée et la saillie (14, 114) est insérée dans le trou (24, 124), et
dans lequel, à l'étape d'assemblage, l'assemblage par friction - malaxage est appliqué sur une seconde partie aboutée (J12) formée avec une périphérie externe de la saillie (14, 114) aboutée avec une paroi du trou (24, 124).

8. Procédé pour fabriquer une chemise refroidie par liquide (1, 1A, 101, 101A) selon la revendication 7, dans lequel l'étape de préparation comprenant les étapes consistant à :
former une gaine (30, 130) qui a une première base (31, 131) formée avec un premier métal gainé sur une seconde base (41, 141) formée avec le second métal ;
couper dans un premier temps, la première base (31, 131) afin de former le premier substrat (21, 121) et un bloc (43, 143) ;
couper, dans un second temps, la seconde base (41, 141) afin d'avoir le bord périphérique du premier substrat (21, 121) exposé et former le second substrat (22, 122) ; et
former des ailettes afin de couper le bloc (43, 143) avec plusieurs dispositifs de coupe ayant des dispositifs de coupe à disque (M2) en parallèle afin de former la pluralité d'ailettes (23, 123).

9. Procédé pour fabriquer une chemise refroidie par liquide (1, 1A, 101, 101A) selon la revendication 7 ou 8, dans lequel, à l'étape d'assemblage, l'assemblage par friction - malaxage est appliqué dans un état dans lequel seule la broche de malaxage (F2) de l'outil rotatif (F) est en contact avec la paroi périphérique (11, 111) et le premier substrat (21, 121).

10. Procédé pour fabriquer une chemise refroidie par liquide (1, 1A, 101, 101A) selon la revendication 9, comprenant en outre l'étape consistant à :
agencer un élément auxiliaire pour agencer un élément auxiliaire (106, 106A) le long de la première partie aboutée (J11),
dans lequel, à l'étape d'assemblage, l'assemblage par friction - malaxage est appliqué sur la première partie aboutée (J11) dans un état dans lequel seule la broche de malaxage (F2) est en contact avec la paroi périphérique (11, 111), le premier substrat (21, 121) et l'élément auxiliaire (106, 106A),
dans lequel de préférence, à l'étape d'assemblage, une condition d'assemblage est réglée afin de générer une bavure (V) sur l'élément auxiliaire (106, 106A) et le procédé comprend en outre l'étape consistant à : retirer l'élément auxiliaire (106, 106A) généré avec la bavure (V), et/ou
dans lequel, de préférence, à l'étape d'assemblage, l'assemblage par friction - malaxage est appliqué dans un état dans lequel un axe central pour la rotation de l'outil rotatif (F) est incliné vers un intérieur du corps de chemise (2, 2A, 102, 102A).

11. Procédé pour fabriquer une chemise refroidie par liquide (1, 1A, 101, 101A) selon l'une quelconque des revendications 7 à 10, dans lequel le premier métal est réalisé avec un alliage d'aluminium et le second métal est réalisé avec un alliage de cuivre.

12. Chemise refroidie par liquide (1, 1A, 101, 101A) comprenant :
un corps de chemise (2, 2A, 102, 102A) qui a un fond (10, 110), une paroi périphérique (11, 111) s'étendant vers le haut à partir d'un bord périphérique du fond (10, 110) et une partie étagée (115) formée au niveau d'un bord périphérique interne de la paroi périphérique (11, 111) ; et
un corps de joint d'étanchéité (3, 3A, 103, 103A) qui a un premier substrat (21, 121) formé avec un premier métal en forme de plaque, un second substrat (22, 122) formé avec un second métal en forme de plaque afin d'avoir un bord périphérique du premier substrat (21, 121) exposé sur une face avant (21a, 121a) du premier substrat (21, 121), et une pluralité d'ailettes (23, 123) agencées en parallèle sur une face arrière (21b, 121b) du premier substrat (21, 121),
dans laquelle l'assemblage par friction - malaxage est appliqué sur une première partie aboutée (J11) qui est formée avec une face latérale étagée (115b) de la partie étagée (115) aboutée avec une face latérale (121c) du premier substrat (21, 121), et une région plastifiée (W, W11, W12) est formée dans le bord périphérique du premier substrat (21, 121),
dans laquelle un support (12, 112) ayant une saillie (14, 114) sur sa face d'extrémité (12a, 112a), est formé sur le fond (10, 110) du corps de chemise (2, 2A, 102, 102A),
dans laquelle le premier substrat (21, 121) est formé pour avoir un trou (24, 124) à l'intérieur de ce dernier et le second substrat (22, 122) est formé pour avoir une proximité du trou (24, 124) exposé, et
dans lequel l'assemblage par friction - malaxage est appliqué sur une seconde partie aboutée (J12) qui est formée avec une périphérie externe de la saillie (14, 114) aboutée avec une paroi du trou (24, 124).
